# NEW EUROPEAN PATENT SPECIFICATION

(11) **EP 1 134 073 B2**
(45) Date of publication and mention of the opposition decision: **17.12.2014**
(45) Mention of the grant of the patent: 04.01.2006
(21) Application number: 01302373.4
(22) Date of filing: 14.03.2001
(51) Int. Cl.: B32B 27/32, C23C 16/40

(54) **Gas barrier film**
Gassperrfilm
Film formant barrière aux gaz

(30) Priority: 14.03.2000 JP 2000076354; 02.10.2000 JP 2000302729; 18.10.2000 JP 2000318013; 18.10.2000 JP 2000318014
(43) Date of publication of application: 19.09.2001
(60) Divisional application: 05000465.4
(73) Proprietor: DAI NIPPON PRINTING CO., LTD., Tokyo 162-8001 (JP)
(72) Inventor: Komada, Minoru, c/o Dai Nippon Printing Co., Ltd., Shinjuku-ku, Tokyo-to 162-8001 (JP)
(74) Representative: Beck Greener

(56) References cited:
- EP-A- 0 446 878
- EP-A- 0 993 940
- WO-A-93/24243
- WO-A-97/37053
- DE-A- 19 618 111
- US-A- 5 616 369
- US-A- 5 688 556
- US-A- 6 027 793
- DATABASE WPI Section Ch, Week 199648 Derwent Publications Ltd., London, GB; Class A12, AN 1996-481035 XP002169739 & JP 08 244158 A (KURARAY CO LTD), 24 September 1996 (1996-09-24)
- DATABASE WPI Section Ch, Week 199237 Derwent Publications Ltd., London, GB; Class L03, AN 1992-304556 XP002169740 & JP 04 210464 A (OIKE KOGYO KK), 31 July 1992 (1992-07-31)

## Description

### BACKGROUND OF THE INVENTION

The present invention relates to a gas barrier film that is mainly used as a packing material for food, medicines and the like, and as a packaging material for electronic devices and the like, and more particularly relates to a gas barrier film having silicon oxide film which is excellent in gas barrier property.

A gas barrier film is mainly used as a packaging material for food, medicines and the like to prevent the influence of oxygen and water vapor and the like which may cause to change the quality of contents, and as a packaging material for electronic devices and the like to prevent elements which are formed in liquid crystal display panels, EL display panels and the like from contacting with oxygen and water vapor to cause deterioration of their performance. Furthermore, in recent years, a gas barrier film is used in some parts where glass and the like have so far been used, because of making them have flexibility, the shock resistance and the like.

Such a gas barrier film generally has a composition in which a plastic film is used as a base material and a gas barrier layer is formed on one side or both sides of the base material. And the gas barrier film is formed with various methods, including the CVD method, the PVD method and the sputtering method, but even in case of using any method, conventional gas barrier films have only about 2 cc/m²/day in oxygen gas transmission rate (OTR) and about 2 g/m²/day in water vapor transmission rate (WVTR) and were still insufficient when use in applications required higher gas barrier property.

As a dry film forming method of a film having gas barrier property on a plastic base material, some methods are known in which a silicon oxide film (a silica film) and an aluminium oxide film (an alumina film) can be formed using a dry film forming method, including the plasma CVD method. For example, these methods are described in Japanese Patent Application Laid-Open-Nos. 8-176326, 11-309815 and 2000-6301 and others. In particular, the plasma CVD method has advantages that a silicon oxide film and aluminium oxide film having excellent gas barrier property and flexibility can be formed without damaging a base material of a high polymer resin polymer resin with heating.

WO 93/24243 discloses the manufacture of a gas barrier film by using plasma CVD method to form a silicon oxide film from an organosilicon vapor and an oxidising vapor. Such films are said to comprise an appreciable amount of organic residues from the use of the organosilicon component.

The gas barrier property of a gas barrier film is usually improved with the increase in thickness of a vapor deposition barrier layer. In recent years, however, J.T. Felts et al. (34th Annual Technical Conference Proceedings (1991), p.99 to 104) and J.E. Klemberg-Sapieha et al. (36th Annual Technical Conference Proceedings (1993), p.445 to 449) have pointed out in Society of Vacuum Coaters that a barrier film is cracked with the stress relaxation within the film because of increasing in the film thickness, resulting in rather enhancing its gas transmission rate.

### SUMMARY OF THE INVENTION

The present invention has been achieved with a view to these circumstances and is mainly aimed at providing a gas barrier film having an extremely excellent gas barrier property while keeping the film in a predetermined thickness.

To achieve the purpose mentioned above, the present invention provides a gas barrier film comprising a base material and a silicon oxide vapour deposition film formed on both sides or one side of the base material, wherein:
the silcon oxide film is formed by the plasma CVD method and contains from 170 to 200 oxygen atoms and 30 or less carbon atoms per 100 silicon atoms, and further has an IR absorption peak based on the vibration of Si-O-Si between 1055 and 1065 cm⁻¹;
the distance between grains formed on the surface of said silicon oxide film is from 5 to 40 nm;
the thickness of the silicon oxide vapour deposition film is from 5 nm to 30 nm; and
the silicon oxide film has a refractive index of 1.45 to 1.48.

According to the present invention, an area through which a gas is transmitted can be made to be small and a gas barrier film having extremely excellent gas barrier property can be therefore made by controlling the distance between grains formed on the surface of the vapor deposition film acting as a gas barrier film in the above-mentioned range.

In the invention, the vapor deposition film mentioned above is a silicon oxide film.

According to this invention, the film can be made to be a gas barrier film having extremely excellent gas barrier property by controlling the properties comprising of the ratio of components in silicon oxide film and of the peak position of infrared absorption band of the stretching vibration of Si-O-Si observed in the range 1055-1065 cm⁻¹. The silicon oxide film contains from 170 to 200 oxygen atoms and 30 or less carbon atoms per 100 silicon atoms. A silicon oxide film having these properties becomes a SiO₂-like film which is dense and which has a small quantity of impurities.

In the invention, said silicon oxide film has a refractive index of 1.45 to 1.48 in a gas barrier film. That is because the gas barrier property can be still more improved by controlling the refractive index of silicon oxide film acting as a gas barrier film in the above-mentioned range.

Preferably, said silicon oxide film has an E' center observed by measurement with the electron spin resonance method (ESR method).

The silicon oxide film having silicon atoms containing E' center, in other words, unpaired electrons has a film structure of being densely distorted and can be therefore made to be a gas barrier film extremely excellent in gas barrier property.

The density of said E' center is preferably 5 x 10¹⁵ spins/cm³ or more.

The silicon oxide film having the density of the E' center of 5 x 10¹⁵ spins/cm³ or more can be considered to have surely a film structure of being densely distorted, because a gas barrier film having this structure is very excellent in gas barrier property.

Preferably, said silicon oxide film has an infrared absorption peak based on the stretching vibration of CO molecules that exists between 2341±4 cm⁻¹.

According to this invention, a gas barrier film having extremely excellent gas barrier property can be made by controlling the property comprising of IR absorption in a silicon oxide film acting as a gas barrier film as mentioned above.

In the invention, it is preferable that oxygen gas transmission rate is 0.5 cc/m²/day or less and water vapor transmission rate is 0.5 g/m²/day or less.

Because when the oxygen gas transmission rate and water vapor transmission rate of a gas barrier film are controlled within the above-mentioned ranges, the film hardly transmits oxygen and water vapor which may cause to change the quality of contents and hence can be preferably used in applications that require high gas barrier property.

In the invention, the thickness of said vapor deposition film is in the range of 5 to 30 nm.

Because according to the present invention, even in case where an extremely thin vapor deposition film of 5 to 30 nm is formed, the film can exert an excellent gas barrier property and further becomes difficult to be cracked. In addition, because a gas barrier film in which a vapor deposition film is formed in the thickness within the range does not be damaged in transparency, appearance and the like, and increase in the curl of the film can also be retarded, resulting in preferable productivity.

Moreover, in the present invention, there is provided a laminated material, wherein a heat sealable resin layer is provided on the surface of at least one side of a gas barrier film according to the invention. When such a laminated material is used a packing container can be obtained by heat-sealing a heat sealable resin layer in the above-mentioned laminated material to make a bag or case, and since this packaging container is excellent in gas barrier property, the container can be suitably used as a packing material for food and medicines, further for electronic devices and the like.

And, in the present invention, there is provided a laminated material, wherein an electrically conductive layer is formed on the surface of at least one side of the gas barrier film. When such a laminated material is used an image display medium can be made by forming an image display layer on the above-mentioned electrically conductive layer. This image display medium can be made to be excellent in weather resistance and in shock resistance because a base material to be used is excellent in gas barrier property and in flexibility.

As illustrated above, the gas barrier film of the present invention can be made as a gas barrier film extremely excellent in gas barrier property by not only conventionally adjusting the thickness of a deposition film, but also controlling the composition of the deposition film which acts as a gas barrier film, distance between grains which are formed on surface, the presence and absence of the E' center observed by an electron spin resonance method (ESR method), the presence and absence of CO molecule absorbed, and the like.

Further, the gas barrier film of the present invention has an oxygen gas transmission rate (OTR) of 0.5 cc/m²/day or less and a water vapor transmission rate (WVTR) of 0.5 g/m²/day or less, and can be preferably used for uses for which high gas barrier property is required, for example, and the packaging materials of provisions, pharmaceuticals and the like, the packaging materials of electronics devices and the like.

### BRIEF DESCRIPTION OF THE DRAWINGS

Fig. 1 is a schematic sectional view showing an example of the structure of a gas barrier film of the present invention.
Fig. 2 is a schematic sectional view showing grains on the surface of a vapor deposition film of the present invention.
Fig. 3 is an enlarged view of a surface of the gas barrier film shown in Fig. 2.
Fig. 4 is a schematic sectional view showing an example of a laminated material that uses the gas barrier film of the present invention.
Fig. 5 is a schematic sectional view showing another example of a laminated material that uses the gas barrier film of the present invention.
Fig. 6 is a schematic sectional view showing another example of a laminated material that uses the gas barrier film of the present invention.
Fig. 7 is a schematic plan view showing an example of a packing container that uses the gas barrier film of the present invention.
Fig. 8 is a schematic perspective view showing another example of a packing container that uses the gas barrier film of the present invention.
Fig. 9 is a plan view showing a blank board that is used for producing the packing container shown in Fig 8.
Fig. 10 is a schematic sectional view showing an example of a laminated material that uses the gas barrier film of the present invention.
Fig. 11 is a block diagram showing an example of a plasma CVD coating device.
Fig. 12 is a block diagram showing an example of a plasma CVD coating device equipped with a winding mechanism.
Fig. 13 is a block diagram showing an example of a winding type hollow cathode ion plating coating device.

### BRIEF DESCRIPTION OF THE PREFERRED EMBODIMENTS

A gas barrier film of the present invention will be concretely described below using drawings.

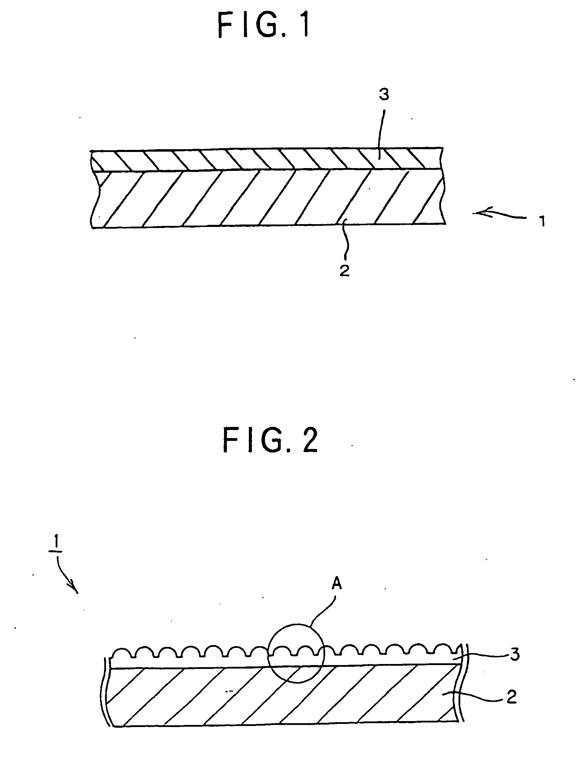

Fig. 1 is a schematic sectional view showing an example of the composition of a gas barrier film. As shown in Fig. 1, a gas barrier film 1 of the present invention is composed of a base material 2 and a vapor deposition film 3 formed on both sides or one side of the base material 2. Thereinafter, this vapor deposition film and base material, further, the production method of this gas barrier film will be described, respectively.

### A. Vapor deposition film

A vapor deposition film in the present invention is a silicon oxide film formed by the plasma CVD method. This silicon oxide film is characterised in that the film contains from 170 to 200 oxygen atoms and 30 or less carbon atoms per 100 silicon atoms, and further has a peak position of IR absorption band based on the stretching vibration of Si-O-Si that exists between 1055 and 1065 cm⁻¹. That is, extremely excellent gas barrier property has been exerted by controlling the properties comprising of the ratio of components in the silicon oxide film 3 acting as a gas barrier film and the peak position of IR absorption band within the above-mentioned range.

The above-mentioned silicon oxide film contains from 170 to 200 oxygen atoms and 30 or less carbon atoms per 100 silicon atoms and is formed so that a peak position of IR absorption band based on the stretching vibration of Si-O-Si exist between 1055 and 1065cm⁻¹. Further, at this time, the silicon oxide film has a refractive index of 1.45 to 1.48. A gas barrier film 1 that has a silicon oxide film 3 with such properties will exert an extremely excellent gas barrier property.

In order to make the ratio of each of component of Si, O and C so that the number of oxygen atoms is from 170 to 200 and the number of carbon atoms is 30 or less to the number of silicon atoms of 100, the flow ratio of organic silicon compound gas to oxygen gas, the magnitude of closing electric power per unit flow rate of the organic silicon compound gas, and others are adjusted. As a result, the ratio can be controlled within the above-mentioned range. In particular, it is preferable to control so as to restrain the mixing of C. For example, by adjusting the flow ratio of (oxygen gas/organic silicon compound gas) within the range of about 3 to 50, a SiO₂-like film can be formed to restrain the mixing of C, and by increasing the magnitude of closing electric power (charged power) per unit flow rate of the organic silicon compound gas, Si-C bond can be easily cut to restrain the mixing of C into the film. More, the upper limit of the flow ratio is defined as a matter of convenience, and there is no special problem even if the flow ratio is over 50. Since a silicon oxide film having a component composition in this range has a small number of Si-C bonds, the film becomes a SiO₂-like uniform film and exerts an extremely excellent gas barrier property. Such a component rate is evaluated by the results measured with a device that can measure quantitatively each component of Si, O and C. Typical measurement devices are those of ESCA (Electron spectroscopy for chemical analysis), RBS (Rutherford back scattering), and Auger electron spectroscopy methods.

The case where the O content is less than 170 atoms per 100 silicon atoms is often seen in case where the flow ratio of (oxygen gas/organic silicon compound gas) is small (in case where the flow of oxygen gas is relatively low) and in case where the magnitude of closing electric power per unit flow rate of the organic silicon compound gas is small. Consequently, the C content becomes high. As a result, many Si-C bonds are contained in the film, and the film is not a SiO₂-like uniform film and has high oxygen transmittance (oxygen gas transmission rate) and water vapor transmittance (water vapor transmission rate). Consequently, the film cannot exert sufficient gas barrier property. Further, the number of oxygen atoms is difficult to exceed 200 per 100 Si atoms stoichiometricallly. Moreover, the case where the C content is over 30 atoms per 100 Si atoms is often seen under the same condition as the case where the O content, is less than 170 atoms per 100 Si atoms, that is, in case where the flow ratio of (oxygen gas/organic silicon compound gas) is small (in case where the flow of oxygen gas is relatively low) and in case where the magnitude of closing electric power per unit flow rate of the organic silicon compound gas is small, and Si-C bonds are retained in the film as they are. As a result, the film is not a SiO₂-like uniform film and has high oxygen transmission rate and water vapor transmission rate. Consequently, the film cannot exert sufficient gas barrier property. On the other hand, the lower limit of the C content is not especially defined, but the lower limit value for the actual film forming process may be defined to be 10 atoms per 100 Si atoms. Further, though it is not easy as a matter of fact to make the C content to be less than 10 atoms per 100 Si atoms, the C content may be less than 10 atoms per 100 Si atoms and a SiO₂-like uniform film can be obtained.

In order to make the peak position of absorption band based on the stretching vibration of Si-O-Si to be between 1055 and 1065 cm⁻¹ in IR measurement, the flow ratio of organic silicon compound gas to oxygen gas and the magnitude of closing electric power per unit flow rate of organic silicon compound gas are adjusted so as to make a silicon oxide film to be a SiO₂-like uniform film as much as possible. As a result, the peak position of absorption band can be controlled within the above-mentioned range. For example, by adjusting the flow ratio of (oxygen gas/organic silicon compound gas) within the range of about 3 to 50, and by increasing the magnitude of closing electric power per unit flow rate of the organic silicon compound gas to make it easy to cut Si-C bond, a SiO₂-like film can be formed. More, the upper limit of the flow ratio is defined as a matter of convenience, and there is no special problem even if the flow ratio is over 50. A silicon oxide film in which the peak position of IR absorption band appears in the range described above exerts an extremely excellent gas barrier property because the film has Si-O bonds that are peculiar to a SiO₂-like uniform film. A peak position of IR absorption band is measured and evaluated with an infrared spectrophotometer for IR measurement. It is preferable to measure infrared absorption spectrum with an infrared spectrophotometer equipped with an ATR (multiple reflection) measuring apparatus. At this time, it is preferable that a germanium crystal is used as a prism and measurement is carried out at an incident angle of 45°.

The case where no peak position of IR absorption band is in this range is often seen in cases where the flow ratio of (oxygen gas/organic silicon compound gas) is small (in cases where the flow of oxygen gas is relatively low) and in case where the magnitude of closing electric power per unit flow rate of the organic silicon compound gas is small. Consequently, the C content becomes high. As a result, Si-C bonds are contained in the film and the number of Si-O bonds that are peculiar to a SiO₂-like uniform film is relatively decreased. Therefore, the peak position of IR absorption band does not appear in the range mentioned above. A silicon oxide film thus obtained has high oxygen transmission rate and water vapor transmission rate. Consequently, the film cannot exert sufficient gas barrier property.

In order to make the refractive index of a silicon oxide film to be 1.45 to 1.48, the flow ratio of organic silicon compound gas to oxygen gas and the magnitude of closing electric power per unit flow rate of organic silicon compound gas are adjusted. As a result, the refractive index can be controlled within the above-mentioned range. For example, the refractive index can be controlled by adjusting the flow ratio of (oxygen gas/organic silicon compound gas) within the range of about 3 to 50. More, the upper limit of the flow ratio is defined as a matter of convenience, and there is no special problem even if the flow ratio is over 50. A silicon oxide film having a refractive index within this range becomes a SiO₂-like film, which is dense and which has a small quantity of impurities, and exerts an extremely excellent gas barrier property. Such a refractive index is evaluated by the refractive index at 633 nm using an optical interference method after measuring transmittance and reflectivity with an optical spectroscope.

The case where the refractive index is less than 1.45 is often seen in cases where the flow ratio of organic silicon compound gas to oxygen gas is out of the above-mentioned range and in cases where closing electric power per unit flow rate of organic silicon compound gas is low and hence silicon oxide film that is low density and coarse is obtained. Since the deposited silicon oxide film is coarse and has high oxygen transmission rate and water vapor transmission rate, the film cannot exert sufficient gas barrier property. On the other hand, the case where the refractive index is over 1.48 is often seen in cases where the flow ratio of organic silicon compound gas to oxygen gas is out of the above-mentioned range and in cases where impurities, including C (carbon), are mixed. And the formed silicon oxide film is coarse and has high oxygen transmission rate and water vapor transmission rate. Consequently, the film cannot exert sufficient gas barrier property.

A gas barrier film in which a silicon oxide film having each property mentioned above is formed in a thin thickness of 5 to 300 nm can exert an excellent gas barrier property and has little possibility of being cracked in the silicon oxide film. In cases where the silicon oxide film is less than 5 nm in thickness, the silicon oxide film occasionally cannot cover the whole of the base material, and the gas barrier film cannot therefore improve its gas barrier property. On the other hand, when the thickness of the silicon oxide film is over 300 nm, there may be easily occurred such problems that the film is easily cracked, the transparency and external appearance are lowered, the curl of the film is increased, and the mass production becomes difficult causing decreased productivity and increased production cost, and the like.

Moreover, in the case where a gas barrier film of the present invention is used in applications requiring flexibility like packing material and the like, the thickness of the film is 5 to 30 nm in due consideration of the mechanical properties and applications of a silicon oxide film to be formed. By making the thickness of the silicon oxide film to be 5 to 30 nm, it is possible for the film to have flexibility as a packing material and to be protected from the occurrence of a crack when being bent.

When a gas barrier film is used in such an application as mentioned above, the film can be thinner than any conventional film having nearly an equal gas barrier property.

A silicon oxide film in the present invention is not especially limited to be formed on one side or both sides of the above-mentioned base material, but is formed by the plasma CVD method. The plasma CVD method is a method in which a raw material gas at a constant pressure is kept to be a plasma state by the electric discharge and activated particles generated in the plasma accelerate chemical reactions on the surface of the base material to form a film. This plasma CVD method can form a film of a desired material at so low temperature as not to cause any thermal damage to a polymer resin (the range of about -10 to 200 °C), and the method has an advantage that the kind and physical properties of an obtained film can be controlled by the kind and flow rate of a raw material gas, film forming pressure, closing electric power, and the like.

A silicon oxide film 3 is formed on a base material by reacting an organic silicon oxide gas with a gas having oxygen atoms, above all, with an oxygen gas in plasma that is generated when direct current or electric power having a constant frequency in the range from low frequency to high frequency is applied on electrodes while a mixed gas of an organic silicon compound gas and oxygen gas is provided at a predetermined flow rate into a reaction chamber for a plasma CVD device. The type of a plasma CVD device to be used is not especially limited and various types of plasma CVD devices can be used. Usually, a long polymer resin film is used as a base material, and a continuously film forming device is preferably used in which a silicon oxide film can be continuously formed with conveying the base material.

Furthermore, though the silicon oxide film may be transparent, a layer with inferior transparency among base materials or other laminated materials is freely laminated to provide in all kinds of applications, and transparency and its degree in a gas barrier film required as a final product vary with all kinds of applications. For example, in case where a gas barrier film made of a silicon oxide film is used as packing material, it is permitted to print the film with colored ink and the like for light shielding in order to protect the contents from light. It is also possible to laminate a layer, in which any of additives including antistatic agents and fillers and having factors to reduce the transparency of the whole of a gas barrier film is blended, or to laminate a metal foil without transparency and the like. However, in case a gas barrier film is used in applications, including a gas barrier film for a film liquid crystal display, a gas barrier film for a film organic EL display or a gas barrier film for a film solar cell, since the transparency of the whole of the gas barrier film is required, the effect from the transparency of a silicon oxide film is great.

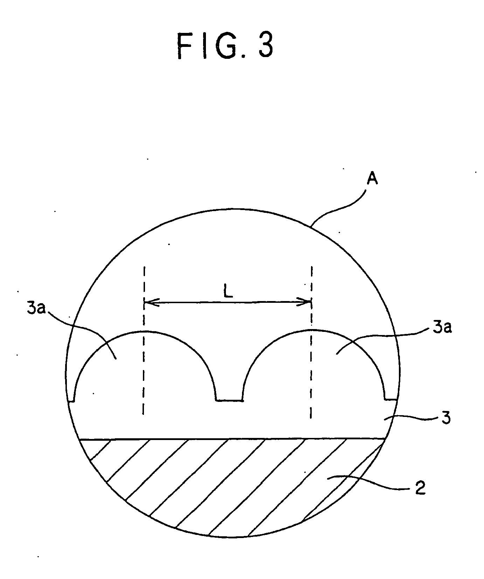

A vapor deposition film 3 in the present invention is characterized in that the film is formed on either both sides or one side of a base material 2 as shown in Fig. 2 and Fig. 3 and a distance L between two grains of 3a formed on the surface of the vapor deposition film 3 is from 5 to 40 nm.

The part of grain 3a is a part where crystallinity is high in the vapor deposition film 3 and that does not easily allow gas and water vapor to be transmitted. Therefore, the gas barrier property of a vapor deposition film is improved by keeping the distance L between grains in the above-mentioned range, because areas where a gas and the like can be transmitted (outside the grain areas) becomes small. In case where the distance L between the grains is in the above-mentioned range, that is, from 5 to 40 nm, a vapor deposition film with good barrier property is obtained. The distance L between grains is more preferable to be in the range of 10 to 30 nm.

Here the grain 3a, which is formed on the surface of the vapor deposition film 3, will be described. A grain means a part that appears to be island-shaped when the section of an AFM image obtained by observing the surface of a vapor deposition film with an atomic force microscope (AFM) is divided at a predetermined height and binarized. That is, unevenness is formed on the surface of the vapor deposition film 3, and the unevenness is observed and image processed using an atomic force microscope to make clear the unevenness, and the island-shaped part, in other words, the convex part obtained by the image processing is a grain.

Furthermore, the distance L between grains means the distance from the peak of a grain (the top of the convex part) to the peak of another grain adjacent to that grain. From the distance L between the grains, it can be seen how many large grains (convex portions) exist per unit length, and the density of grains formed on the surface of a vapor deposition film is also understood.

In the present invention, a silicon oxide film is used in view of easiness of production, general-purpose properties of applications, and the like.

The above-mentioned vapor deposition film is formed by the plasma CVD method. That is because in case where a gas barrier film of the present invention is produced by the plasma CVD method, the film has flexibility as a whole and can be used in various applications.

In order to measure the distance between grains in a film produced by the plasma CVD method, as described below, it is also possible that grain parts with high crystallinity are exposed on the surface of the film by treating it with a hydrofluoric acid aqueous solution and then the distance between these grains is measured with a surface shape measuring device, including AFM.

Furthermore, in order to produce a gas barrier film of the present invention, though it is necessary to adjust the distance between grains that are formed on the surface of a vapor deposition film, in case where the film is formed by the above-mentioned plasma CVD method and the like, it is preferable to make a vapor deposition film forming material in a state having energy reach the surface of a base material and to increase closing electric power to form a structurally stable and dense film.

Besides, it is also preferable to increase the temperature of a base plate because a structurally stable and dense film can also be formed by such a way that molecules for vapor deposition are set in the state so that they can easily migrate on the surface of the base material when a vapor deposition film is formed.

A vapor deposition film in the present invention is a silicon oxide film, and this silicon oxide film in the present invention preferably has an E' center which is observed by measurement with an electron spin resonance method (an ESR method).

First, an E' center will be described.

An E' center is an unpaired electron, and the following [Chemical formula 1] is a structural formula of silicon atom having an E' center, in other words an unpaired electron.

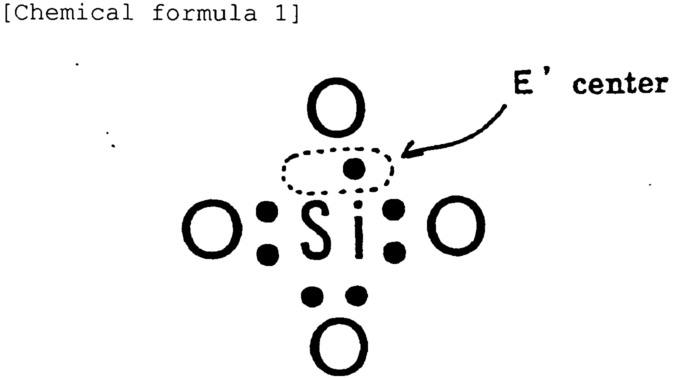

A normal silicon atom has four arms to form a covalent bond with other atoms and thus a silicon atom in a normal silicon oxide film is bonded with four adjacent oxygen atoms. However, in case of a silicon atom having an E' center, in other words, an unpaired electron, though three out of four arms are bonded with oxygen atoms, the fourth arm exists as an unpaired electron and is not bonded with an oxygen atom. From this reason, a silicon oxide film composed of a silicon atom having an E' center has a construction in which the film is densely distorted. Therefore, a silicon oxide film having an E' center can form a gas barrier film with an extremely excellent gas barrier property because a silicon oxide film having an E' center is in a state in which more crystals are filled (because one bond between silicon and oxygen is lacked, other silicon atoms or oxygen atoms can get in the lacked part) compared with the crystal construction of a normal silicon oxide film.

Here, the density of an E' center which is observed by measurement with the above described electron spin resonance method (the ESR method) is preferable to be 5 × 10¹⁵ spins/cm³ or more.

Because a silicon oxide film in which the density of the E' center is 5 x 10¹⁵ spins/cm³ or more has a construction in which the film is surely densely distorted.

Further, the density of an E' center is preferable to be 1 x 10¹⁸ spins/cm³ or less. This is because that increase in the density of the E' center means that the number of bonds between silicon atom and oxygen atom becomes small and it is difficult to form a film as a crystal when the density exceeds the above-mentioned numerical value.

Next, an electron spin resonance method (an ESR method) will be described.

A substance having an unpaired electron like a radical and a transition metal ion and indicating magnetism with the spin is called a paramagnetic substance, and a substance not having an unpaired electron is called a diamagnetic substance. Here, an electron spin resonance method (an ESR method) is an absorption spectrum method with an unpaired electron in a paramagnetic substance, and information about the electron state and its environment can be obtained with the electron spin resonance method (the ESR method).

When a silicon oxide film composing a gas barrier film in the present invention is measured, it is possible to use any of known electron spin resonance methods and it is not needed to especially limit a measuring device and the like to be used.

Where the film is formed by the above-mentioned plasma CVD method, it is preferable to increase closing electric power in plasma generating means. Because a silicon oxide film forming material is provided with energy by increasing closing electric power, molecules as raw materials can be made in very activated states to increase the probability of cleaving a bond, resulting in forming a film having an E' center (an unpaired electron).

Moreover, it is also preferable to reduce pressure under which a film is formed. The probability of collision of atoms (silicon atoms and oxygen atoms) to form a silicon oxide film can be lowered by reducing pressure during forming a film, resulting in forming a film having an E' center (an unpaired electron).

Preferably, the silicon oxide film is characterized by having an IR absorption peak based on the stretching vibration of CO molecules in 2341±4 cm⁻¹.

When the film has the above-mentioned IR absorption peak, the reason that a gas barrier property is improved is not clear but can be considered as follows. The fact that the film has an IR absorption peak is considered to indicate that CO molecules are physically adsorbed, in other words, incorporated in a state of gas into the film.

A conventional silicon oxide film is comprised of the bonds of silicon atoms (Si) and oxygen atoms (O), and a lot of voids exist between the silicon atoms and oxygen atoms. However, because a silicon oxide film of the present invention is in the state in which CO molecules are incorporated in a state of gas into the film, that is, in the state in which voids among silicon atoms and oxygen atoms composing the silicon oxide film are filled with CO molecules as described above, the film has few voids compared with a conventional silicon oxide film and, as a result, the film is considered to have an excellent gas barrier property.

And in case of considering as mentioned above, CO molecules that are physically adsorbed into the silicon oxide film in the present invention, that is, CO molecules incorporated into the film are considered to be formed by the decomposition (oxidation) of an organic silicon oxide compound used as a raw material when the silicon oxide film is formed by the plasma CVD method. And the above described CO molecules are formed at the same time as the formation of the silicon oxide film, therefore in case where the formed silicon oxide film has a lot of voids, it can be naturally expected that no physical adsorption occurs and CO molecules are emitted as a gas from the film into the air as it is. In contrast to this, since the silicon oxide film of the present invention has an IR absorption peak based on the stretching vibration of CO molecules in 2341±4 cm⁻¹, it is considered that gaseous CO molecules, which are formed as what is called a byproduct, are clearly physically adsorbed in the film during formation of the silicon oxide film. This can be afforded as a basis for considering that the silicon oxide film of the present invention has such a dense construction that CO molecules can not be emitted to the outside of the film.

Moreover, in case of considering as mentioned above, an IR absorption peak based on the stretching vibration of CO molecules normally appears in 2341 cm⁻¹, but in the present invention, it is settled that the IR absorption peak appears in 2341±4 cm⁻¹ in consideration of the resolution of a device when IR measurement is performed.

Here, to make an IR absorption peak based on the stretching vibration of CO molecules appear in 2341±4 cm⁻¹ in IR measurement, it is better to increase the amount of closing electric power in plasma generating means, because the increase in electric power can improve the cleavage of bonds within molecules of an organic silicon oxide compound used as a raw material of the silicon oxide film and make it easy to form CO molecules. Further, it is also acceptable to make it easy to form CO molecules by controlling the flow ratio of an organic silicon oxide compound as a raw material to oxygen.

Moreover, the strength of an IR absorption peak which appears in the part of 2341±4 cm⁻¹ in the IR measurement based on the stretching vibration of CO molecules is preferable to be 0.005 to 0.3 in absorbance, because if the absorbance within above-mentioned rage is confirmed, it is clear that gaseous CO molecules are physically adsorbed in a silicon oxide film.

It is preferable to measure infrared absorption spectrum with an infrared spectrophotometer equipped with an ATR (multiple reflection) measuring apparatus. At this time, it is preferable that a germanium crystal is used as a prism and measurement is carried out at an incident angle of 45°.

### B. Base material

Next, a base material to composing a gas barrier film of the present invention will be described.

If a base material in a gas barrier film of the present invention is a film that can hold a vapor deposition film having the above-mentioned barrier property, it is not especially limited and it can use any film.

Examples include:
- polyolefine (PO) resin based polymer film;
   including homopolymers or copolymers of ethylene, propylene, butene and the like,
- amorphous polyolefine resin (APO) based polymer film;
   including cyclic polyolefines,
- polyester resin based polymer film;
   including polyethylene terephthalate (PTE) and polyethylene 2,6-naphthalate (PEN),
- polyamide (PA) resin based polymer film;
   including nylon 6, nylon 12, and nylon copolymers,
- polyvinyl alcohol resin based polymer film;
   including polyvinyl alcohol (PVA) resin, and ethylene-vinyl alcohol copolymer (EVOH),
- polyimide (PI) resin based polymer film,
- polyetherimide (PEI) resin based polymer film,
- polysulfone (PS) resin based polymer film,
- polyethersulfone (PES) resin based polymer film,
- polyether etherketone (PEEK) resin based polymer film,
- polycarbonate (PC) resin based polymer film,
- polyvinyl butylate (PVB) resin based polymer film,
- polyallylate (PAR) resin based polymer film,
- fluorinated resin based polymer film;
   including ethylene-tetrafluoroethylene copolymer (ETFE), trifluorochloroethylene (PFA), tetrafluoroethylene-perfluoroalkylvinylether copolymer (FEP), vinylidene fluoride (PVDF), vinyl fluoride (PVF), perfluoroethylene-perfluoropropylene-perfluorovinylether copolymer (EPA),
and others can be used.

And, besides resins listed above, it is possible to use light curing resins, including a resinous composition that is comprised of an acrylate compound having a radical reactive unsaturated linkage, a resinous composition having the above described acrylate compound and a mercapto compound with a thiol group, and a resinous composition that any of oligomers such as epoxy acrylate, urethane acrylate, polyester acrylate, polyether acrylate and the like is dissolved into a multifunctional acrylate monomer, and to use their mixtures and others. Moreover, it is also possible to use materials as a base film, in which material one or more kinds of these resins are laminated by means of lamination, coating and the like.

A base material of the present invention that uses any of the resins listed above may be an undrawn film and an oriented film.

A base material of the present invention can be produced by a conventional known general method. For example, it is possible to produce a practically amorphous and not oriented undrawn base material by melting a resin to be used as a material with an extruder, then by extruding through a ring die or a T die and quenching. Moreover, an oriented base material can be produced by drawing an undrawn base material toward the flow direction of the base material (the vertical shaft) or the rectangular direction to the flow direction of the base material (the horizontal shaft) by the use of known method, including uniaxial drawing, tenter successive biaxial drawing, tenter coincidental biaxial drawing, and tubular coincidental biaxial drawing. Though draw ratio in this case can be properly selected in conformity to a resin used as a raw material of a base material, it is preferable to be 2 to 10 times in the vertical shaft and the horizontal shaft, respectively.

Further, for a base material of the present invention, surface finishing, including corona treatment, flame treatment, plasma treatment, glow discharge treatment, sand blast treatment, and chemical treatment, may be carried out before a vapor deposition film is formed.

In addition, an anchor coating agent layer may be formed on the surface of a base material of the present invention for the purpose of improving its adhesion with a vapor deposition film. As an anchor coating agent used in the anchor coated layer, one kind or a combination of two or more kinds of polyester resin, isocyanate resin, urethane resin, acrylic resin, ethylene vinyl alcohol resin, vinyl modified resin, epoxy resin, modified styrene resin, modified silicon resin, alkyl titanate and others can be used. A conventionally known additive can also be added in these anchor coating agents. And the above-mentioned anchor coating agent can be coated on a base material by such a known method as roll coating, gravure coating, knife coating, dip coating, spray coating, and the like, and then the used solvent, diluent and the like are dried to remove, resulting in forming an anchor coating. The amount of the above-mentioned anchor coating agent applied is preferable to be about 0.1 to 5 g/m² (at dried state).

A base material is convenient when used as a long product in roll form. The thickness of a base material is different depending on the application of the obtained gas barrier film, so it is not defined unconditionally. However, in case where the film is used in a general packing material and in a base material for a packaging material, the thickness is preferable to be 3 to 188 µm.

### C. Production method

A gas barrier film of the present invention, as described above, is comprised of a vapor deposition film of the present invention formed on a base material. The film is made by the plasma CVD method.

As a preferable film forming condition in this plasma CVD method, first, the temperature of a base material when a film is formed is in the range of -20 to 100 °C, preferably in the range of -10 to 30 °C.

Next, an organic silicon compound gas and a gas containing oxygen atoms are used as raw material gases, and the flow ratio of a gas containing oxygen atoms to this organic silicon compound gas is in the range of 3 to 50, preferably in the range of 3 to 10 when the organic silicon compound gas is 1.

And, the higher effect can be obtained by setting the amount of closing electric power per the unit area of plasma generating means in the plasma CVD device to be high, and by forming a space like a magnet and the like for shutting in plasma to raise the reactivity.

Further, as an organic silicon compound gas among the above-mentioned raw material gases, hexamethyldisiloxane (HMDSO), 1,1,3,3-tetramethyldisiloxane (TMDSO), vinyltrimethoxysilane, vinyltrimethylsilane, tetramethoxysilane (TMOS), methyl trimethoxysilane, dimethyldimethoxysilane, trimethylmethoxysilane, tetraethoxysilane (TEOS), dimethyldiethoxysilane, methyldimethoxysilane, ethyldiethoxysilane, and hexamethyldisilazane can be preferably used. Besides, one or more kinds of conventionally known gases, including tetramethyldisiloxane, and normal methyl trimethoxysilane, can be used.

However, in the present invention, for the purpose of forming SiO₂-like film, it is especially preferable to use an organic silicon compound not having carbon-silicon bond within molecule. Concretely, tetramethoxysilane (TMOS), methyltrimethoxysilane, methyldimethoxysilane, tetraethoxysilane (TEOS), methyltriethoxysilane, dimethyldiethoxysilane, methyldimethoxysilane, methyldiethoxysilane, and others can be listed. Among those compounds, it is preferable to use tetramethoxysilane (TMOS) and tetraethoxysilane (TEOS) that have no carbon-silicon bond in the molecules.

And, as a gas containing oxygen atoms, N₂O, oxygen, CO, CO₂ and others can be listed. Among them, oxygen gas is preferably used.

Like this, an organic silicon compound having no carbon-silicon bond is used as a organic silicon compound gas among the raw material gases, in addition, by controlling the temperature of a base material at the beginning of film formation, the flow ratio of raw material gases, and further the amount of closing electric power in plasma generating means in the above-mentioned ranges, respectively, a gas barrier film with better gas barrier property can be obtained. This is because the degradability of the organic silicon compound gas becomes higher and oxygen atoms become to be easily taken in into a film, resulting in forming a SiO₂-like film.

Further, it is preferable to carry out the heat treatment of thus obtained gas barrier film in the range of 50 °C to 200 °C. Thus obtained silicon oxide film can be made to be a silicon oxide film with better gas barrier property through this heat treatment.

When this heat treatment is carried out, in case of a silicon oxide film having an IR absorption peak in 2341±4 cm⁻¹ based on the stretching vibration of CO molecules before the heat treatment), the heat treatment is preferable to be carried out until this IR absorption peak based on the stretching vibration of CO molecules disappear.

The reason why the heat treatment is thus carried out until the IR absorption peak in 2341±4 cm⁻¹ based on the stretching vibration of CO molecules disappear is considered that the vibration of bonds in a molecule becomes strong through the addition of heat energy to the film, spaces where CO molecules can transmit are formed, captured CO molecules come off and then bonds become tighter corresponding to the rate of CO molecules' coming off, and as a result, a more dense film is formed. Consequently, when the film is heated until the above-mentioned IR absorption peak disappears, it is considered that the gas barrier property of the film is more improved. Now, here "the peak disappears" means to be not more than the detection limit of an analytical instrument to be used.

Though the concrete heating time until the above-mentioned peak thus disappears greatly differs depending on the temperature, heating for about 30 minutes or more is needed at temperatures of 50 °C or more, and heating for 5 minutes is needed or more at temperatures of 70 °C or more.

### D. Gas barrier film

A gas barrier film of the present invention exerts an extremely excellent gas barrier property of 0.5 cc/m²/day or less in oxygen transmission rate and 0.5 g/m²/day or less in water vapor transmission rate, more preferably of 0.1 cc/m²/day or less in oxygen transmission rate and 0.1 g/m²/day or less in water vapor transmission rate. Because a gas barrier film of the present invention hardly transmits oxygen and water vapor which cause changes in the qualities of contents, the gas barrier film can be preferably used in such applications as need a high gas barrier property, for example, in packing materials for food, medicines and others, and in packaging materials for electronic devices and the like. Further, the gas barrier film can be used as a base material for, for example, various kinds of displays, because the film has the high gas barrier property and shock resistance together. The film can also be used in cover films for solar cells and the like.

### E. Laminated material

A gas barrier film can be extended in various kinds of applications by further laminating other layers on the above-mentioned gas barrier film to make laminated materials. As other layers to be laminated here, various kinds of layers can be used depending on the applications for which the gas barrier films are used and so they are not limited. But as laminated materials that can effectively use the above-mentioned gas barrier property, the first embodiment in which a heat sealable resin layer is laminated and the second embodiment in which an electrically conductive layer is laminated each on the above-mentioned gas barrier film will be described below.

### 1. First embodiment of Laminated Material

### (Laminated material)

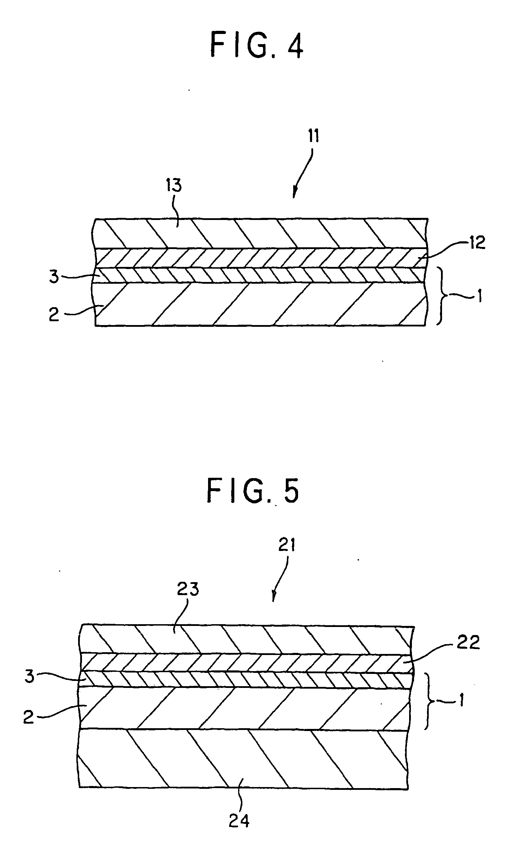

Fig. 4 is a schematic sectional view showing the first embodiment of the laminated material of the present invention. In Fig. 4, a laminated material 11 is fitted with a gas barrier film 1 which has a vapor deposition layer 3 on the one side of a base material 2 and with a heat sealable resin layer 13 which is formed on the vapor deposition layer 3 of this gas barrier film 1 through the intermediary of an anchor coating agent layer and/or an adhesive layer 12.

The anchor coating agent layer 12 composing the laminated material 11 can be formed using, for example, organotitanium anchor coating agents such as alkyl titanate and others, isocyanate anchor coating agents, polyethylene imine anchor coating agents, polybutadiene anchor coating agents, and others. The formation of the anchor coating agent layer 12 can be made by coating an anchor coating agent as mentioned above with such a known method as, for example, roll coating, gravure coating, knife coating, dip coating, spray coating, and the like, and then by drying and removing the used solvent, diluent and the like. The amount of the above-mentioned anchor coating agent applied is preferable to be about 0.1 to 5 g/m² (at dried state).

And the adhesive layer 12 composing the laminated material 11 can be formed using any of all sorts of laminating adhesives, including solvent type, water type, solventless type, or heat melting type, in which laminating adhesives a main component is any of vehicles of, for example, polyurethanes, polyesters, polyamides, epoxides, polymethacrylates, polyvinyl acetates, polyolefins, caseins, waxes, ethylene-methacrylic acid copolymers, polybutadienes, and others. The formation of the adhesive layer 12 can be made by coating a laminating adhesive as mentioned above with such a coating method as, for example, roll coating, gravure coating, knife coating, dip coating, spray coating, and the like, and then by drying and removing the used solvent, diluent and the like. The amount of the above-mentioned laminating adhesive applied is preferable to be about 0.1 to 5 g/m² (at dried state).

As a heat sealable resin used in the heat sealable resin layer 13 composing the laminated material 11, resins that can be melted with heat and welded to each other can be listed. Concretely, following resins can be used; low density polyethylene, medium density polyethylene, high density polyethylene, straight-chain (linear) low density polyethylene, polypropylene, ethylene-vinyl acetate copolymer, ionomer resin, ethylene-acrylic acid copolymer, ethylene-methacrylic acid copolymer, ethylene-methyl methacrylate copolymer, ethylene-propylene copolymer, methylpentene polymer, polybutene polymer, acid modified polyolefin polymers that polyolefin resins such as polyethylene or polypropylene and others are modified with an unsaturated carboxylic acid like acrylic acid, methacrylic acid, maleic acid, maleic anhydride, fumaric acid, itaconic acid and others, polyvinyl acetate resins, polymethacrylic resins, polyvinyl chloride resins, and others. The heat sealable resin layer 13 may be formed by coating with a heat sealable resin as mentioned above, or by laminating with a film or sheet comprising of a heat sealable resin as mentioned above. The thickness of such a heat sealable resin layer 13 can be set to be 5 to 300 µm, preferably to be 10 to 100 µm.

Fig. 5 is a schematic sectional view showing another example of a laminated material in the present embodiment. In Fig. 5, a laminated material 21 is fitted with a gas barrier film 1 which has a vapor deposition layer 3 on the one side of a base material 2, a heat sealable resin layer 23 which is formed on the vapor deposition layer 3 of this gas barrier film 1 through the intermediary of an anchor coating agent layer and/or an adhesive layer 22, and with a base material layer 24 which is fitted on the other side surface (the surface no vapor deposition layer is formed) of a base material 2 of the gas barrier film 1.

The anchor coating agent layer, the adhesive layer 22 and the heat sealable layer 23, which compose the laminated material 21, can be formed similarly to the anchor coating agent layer, the adhesive layer 12 and the heat sealable resin layer 13 which compose the above-mentioned laminated material 11. So the descriptions on them are omitted in here.

As the base material layer 24 composing the laminated material 21, for example, in case the laminated material 21 composes a packing container, the base material layer 24 is the fundamental raw material, consequently it is possible to use a film or sheet of a resin that is excellent in mechanical, physical, chemical and other properties, in particularly, that has strength and is tough, in addition, has thermal resistance. Concretely, drawn (uniaxial or biaxial) or undrawn film or sheet of tough resins can be listed, which resins include polyester resins, polyamide resins, polyaramid resins, polyolefin resins, polycarbonate resins, polystyrene resins, polyacetal resins, and fluorinated resins. The thickness of this base material layer 24 is desirable to be 5 to 100 µm, preferably about 10 to 50 µm.

Further, in the present embodiment, surface printing or reverse printing of desired printing patterns of, for example, letters, figures, marks, patterns, designs and the like may be performed on the base material layer 24 by an usual printing method. Since the transparent barrier film 1 composing the laminated material layer 21 has excellent transparency, letters and others like this can be well recognized by seeing through this transparent barrier film 1.

Furthermore, in the present embodiment, for example, all sorts of paper base materials composing a paper layer can be used as the base material layer 24. Concretely, paper base material having shape adjusting property, flexibility, rigidity and the like, for example, a bleached or unbleached paper base material with strong pasting property, or paper base materials of pure white roll paper, kraft paper, cardboard, processed paper and the like can be used. As a paper base material like this, it is desirable to use a paper material of about 80 to 600 g/m² in basis weight, preferably about 100 to 450 g/m² in basis weight.

Further, in the present embodiment, as the base material layer 24, the film or sheet of a resin mentioned above and a paper base material mentioned above can be used at the same time.

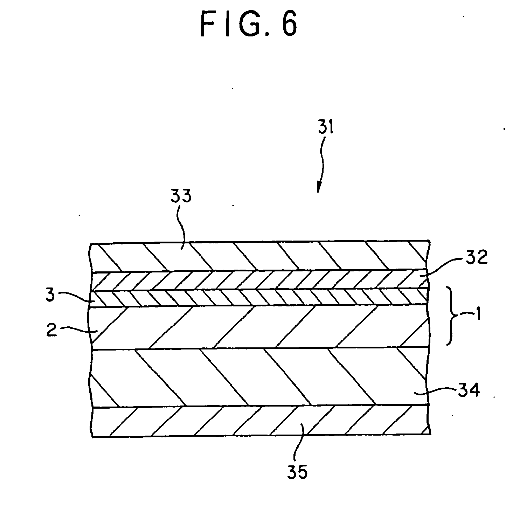

Fig. 6 is a schematic sectional view showing another example in laminated materials of the present embodiment. In Fig. 6, the laminated material 31 is fitted with a transparent barrier film 1 which has a vapor deposition layer 3 on the one side of a base material 2, a heat sealable resin layer 33 which is formed on the vapor deposition layer 3 of this transparent barrier film 1 through the intermediary of an anchor coating agent layer and/or an adhesive layer 32, a base material layer 34 which is fitted on the other side surface (the surface no vapor deposition layer is formed) of a base material 2 of the gas barrier film 1, and with a heat sealable resin layer 35 which is formed on this base material layer 34.

The anchor coating agent layer, the adhesive layer 32 and the heat sealable layers 33 and 35, which compose the laminated material 31, can be formed similarly to the anchor coating agent layer, the adhesive layer 12 and the heat sealable resin layer 13 which compose the above-mentioned laminated material 11, further the base material layer 34 which composes the laminated layer 31 can be formed similarly to the base material layer 24 which composes the above-mentioned laminated layer 21. So the descriptions on them are omitted in here.

More, in the laminated materials in the present embodiment, further, the following films or sheets can be used; for example, films or sheets of resins having a barrier property to water vapor, water and the like, including low density polyethylene, medium density of polyethylene, high density polyethylene, straight-chain low density polyethylene, polypropylene, and ethylene-propylene copolymer, films or sheets of resins having a barrier property to oxygen, water vapor and the like, including polyvinylidene chloride, polyvinyl alcohol, saponified product of ethylene-vinyl acetate copolymer, and films or sheets of various sorts of colored resins having a light shielding property, which films or sheets are made in such a way that after a coloring agent of a pigment and the like, and other desired additives are added into a resin, the mixture is kneaded and then a film or sheet is made.

These materials can be used alone or in combination of two or more materials, and the thickness is optional, but usually it is 5 to 300 µm, preferably about 10 to 100 µm.

Furthermore, when a laminated material of the present embodiment is used in applications of packing containers, the laminated material is also needed strict packing suitability because a packing container is usually put in a severe physical and chemical condition. Concretely, various conditions, including deformation prevention strength, dropping impact strength, pin hole resistance, thermal resistance, sealing performance, quality maintainability, workability, a sanitary property, and the like, are needed. On this account, a material meeting the above-mentioned conditions is selected arbitrarily and used as the base material 2, the base material layer 24 and 34, or other composition members in a laminated material of the present embodiment. Concretely, it is possible to select arbitrarily and use films or sheets of known resins, including low density polyethylene, medium density polyethylene, high density polyethylene, linear low density polyethylene, polypropylene, ethylene-propylene copolymer, ethylene-vinyl acetate copolymer, ionomer resins, ethylene-ethyl acrylate copolymer, ethylene-acrylic acid or methacrylic acid copolymer, methyl pentene polymer, polybutene resins, polyvinyl chloride resins, polyvinyl acetate resins, polyvinylidene chloride resins, vinyl chloride-vinylidene chloride copolymer, polymethacrylic resins, polyacrylonitrile resins, polystyrene resins, acrylonitrile-styrene copolymer (AS resin), acrylonitrile-butadiene-styrene copolymer (ABS resin), polyester resins, polyamide resins, polycarbonate resins, polyvinyl alcohol resins, saponified product of ethylene-vinyl acetate copolymer, fluorinated resins, diene resins, polyacetal resins, polyurethane resins, and nitrocellulose. In addition, for example, films of cellophane and the like, synthetic paper, and others can also be used.

About the above-mentioned films or sheets, any of undrawn, uniaxial or biaxial directionally oriented films or sheets, and others can be used. Further, the thickness is optional, but it is possible to use a thickness selected from the range of several µm to about 300 µm. The lamination position is not particularly limited. And, in the present invention, films or sheets may be a film of any property depending on extrusion film forming, inflation film forming, coating film, and the like.

A laminated material of the present embodiment like the above-mentioned laminated materials 11, 21 and 31 can be produced using a usual method of laminating packing materials; for example, a wet lamination method, a dry lamination method, a solventless dry lamination method, an extrusion lamination method, a T die extrusion molding method, a coextrusion lamination method, an inflation method, a coextrusion inflation method, and the like.

Furthermore, when the above-mentioned lamination is carried out, if necessary, for example, such a pretreatment as corona treatment, ozone treatment, and the like can be performed on the film. And it is also possible to use any of anchor coating agents, for example, isocyanate series (urethane series), polyethylene imine series, polybutadiene series, organotitanium series, and others, or to use any of adhesives known as adhesives for lamination and the like, including polyurethane series, polyacrylate series, polyester series, epoxy series, polyvinyl acetate series, and cellulose series.

### (Packing container)

Next, a packing container using the above-mentioned laminated material will be described. This packing container is made as a bag or a case using the above-mentioned laminated material of the present embodiment by heat-sealing.

Concretely, when the packing container is a soft packing bag, a laminated material of the present embodiment is folded making the surface of its heat sealable resin layer being opposed, or two sheets of the laminated materials of the present invention are piled up, then they are heat-sealed at the peripheral part by any of heat sealing forms of, for example, a lateral sealing type, a two sides sealing type, a three sides sealing type, an all sides sealing type, an envelope close sealing type, a butt-seam sealing type, a puckered sealing type, a flat-bottom sealing type, an angular bottom sealing type, and other types. Like that, sealed parts are formed, resulting in producing various kinds of packing containers according to the present invention.

In the above-mentioned description, heat sealing can be carried out by well known methods of, for example, bar sealing, rotating roll sealing, belt sealing, impulse sealing, high-frequency sealing, ultrasonic sealing, and the like.

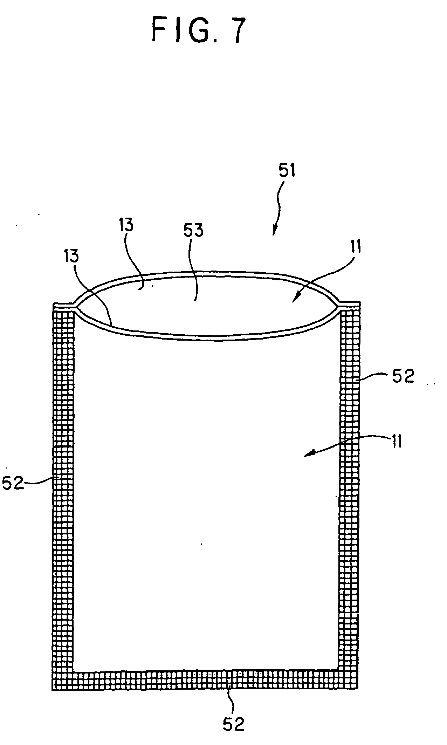

Fig. 7 is a perspective view showing an example of packing containers as mentioned above. A packing container 51 shown in Fig. 7 is produced in such a method that a set of the laminated material 11 of the present invention is folded so as to oppose its heat sealable resin layer 13 and then heat-sealed at three sides of its periphery in the state to form sealed part 52. In this packing container 51, contents can be filled through an opening 53 formed at the remaining one side of the periphery. And, after contents are filled, the above-mentioned opening 53 is heat-sealed to form a sealed part, resulting in a packing container in which contents are filled and packed.

In addition to the container as mentioned above, the packing container of the present invention can be, for example, a self-supporting packing bag (a standing pouch) and the like. And further, a tube container can also be produced using the laminated material of the present invention.

Still more, in the present invention, for example, a bung hole of one piece type, two piece type and the like, or a zipper for opening and shutting and the like can be arbitrarily attached to a packing container as mentioned above.

Moreover, in case where a packing container of the present invention is a paper container including a paper base material for the use of filling liquid, first, a blank board for producing a desired paper container is produced using a laminated material of the present invention in which a paper base material is laminated, and then a paper container and the like for liquid, which is, for example, a brick type, a flat type, or a Goebel top type, can be produced by forming its body, bottom, head, and other parts using this blank board.

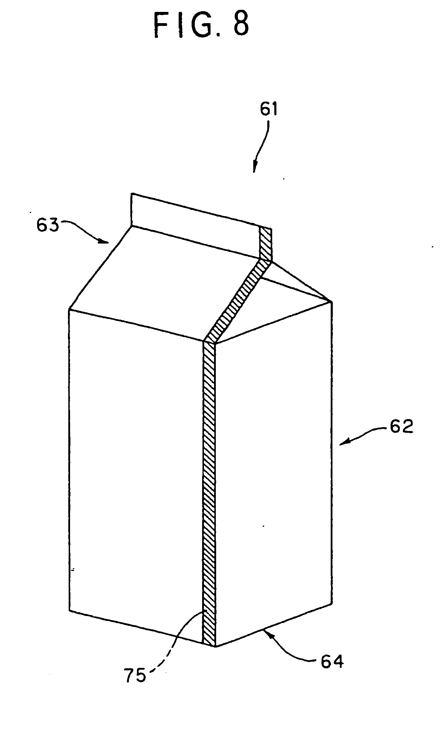

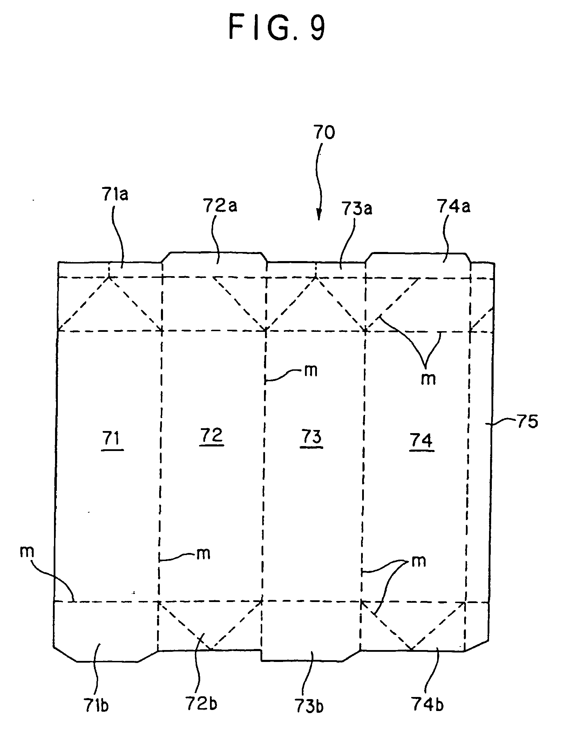

Fig. 8 is a perspective view showing an example of the above-mentioned paper container for filling liquid that is a packing container of the present invention, and Fig. 9 is a plan view showing a blank board that is used in a packing container shown in Fig. 8. For example, using a laminated material 31 of the present invention shown in Fig. 6, the blank board 70 is produced by blanking the laminated material 31 so as to prepare press dotted lines m, m ... for bending, body panels 71, 72, 73 and 74 that compose the body 62 of a container 61, top panels 71a, 72a, 73a and 74a that compose the top 63 of a container 61, bottom panels 71b, 72b, 73b and 74b that compose the bottom 64 of a container 61, and heat-sealing panel 75 for forming the shell in forming a container. This blank board 70 is bent at press dotted lines m, m ..., and the inner part of the edge of the body panel 71 is heat-sealed with the outer part of the heat-sealing panel 75 to form the shell, and then bottom panels 71b, 72b, 73b and 74b are bent at press dotted lines m, m ... and heat-sealed. Finally, after liquid is filled from the top opening, top panels 71a, 72a, 73a and 74a are bent at press dotted lines m, m ... and heat-sealed to form a packing container 61 in which liquid is filled and packed.

A packing container of the present invention is used to fill and pack all sorts of articles, including various eatables and drinkables, chemicals of adhesives, pressure sensitive adhesives and the like, cosmetics, medicines, sundries like chemical body warmers and the like.

### 2. Second embodiment of Laminated Material

### (Laminated material)

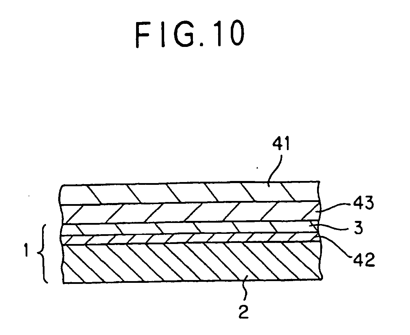

The second embodiment of laminated material of the present invention is a laminated material that is characterized by a conductive layer formed on the surface of at least one side of the above-mentioned gas barrier film. Fig. 10 shows an example of the present embodiment. A laminated material in the present embodiment is made by forming conductive layer 41 on a gas barrier film 1 that is comprised of a base material 2 and a vapor deposition film (a silicon oxide film) 3 formed on the base material 2, but as shown in Fig. 10, an anchor coating layer 42 may be formed between the vapor deposition 3 and the base material 2 to improve adhesion of the vapor deposition film 3. And an overcoat layer 43 may be formed on the vapor deposition layer 3.

A gas barrier film 1 used in the present embodiment is the same as the above-mentioned gas barrier film. So the description is omitted in here.

As the conductive layer 41 used in the present embodiment, for example, an ITO film is used, and it is formed by the sputtering method, the PVD method, and the ion plating method. In the present embodiment, above all, an ITO film obtained by the sputtering method is preferable to obtain the uniform conductivity in the surface.

The thickness of this conductive layer 41 varies to a large extent depending on the composition, applications and the like, but usually the layer is formed in the range of 100 nm to 200 nm.

This conductive layer 41 is preferable to have such properties that resistance values are from 0 to 50 Ω and the transmission rate of all light ray is 85% or more.

For example, when in a liquid crystal display, such a conductive layer 41 can be used as a transparent electrode for activating the liquid crystal.

Further, as an overcoat layer 43 used in the present invention, an ultraviolet cured film of an epoxyacrylate prepolymer having a melting point of 50 °C and more, or an urethane acrylate prepolymer having a melting point of 50 ° C and more can be used, but a heat cured film, which is more stable for heat, may be used if the properties as a display medium application in a liquid crystal and the like are satisfied. However, an ultraviolet curing resin having high productivity is more preferable. Naturally, adhesion to a polymer film and inorganic layer is essential to the film, and it is necessary for the film to have flexibility and chemical resistance. For this purpose, a primer layer, which is usually used, may be prepared.

### (Image display medium)

An image display medium of the present invention is an image display layer that is formed on the above-mentioned conductive layer using a laminated material shown in the above-mentioned second embodiment as a base material.

As image display devices like this, it is possible to cite a nonluminous display like a liquid crystal display that performs a display with gradation by shuttering the brightness of a backlight, and a self-luminous display like a plasma display (PDP), a field emission display (FED) and an electro luminescence display (EL) in which a display is performed by shining a fluorescent material with some kind of energy.

In case where the above-mentioned image display medium is a liquid crystal display, the above-mentioned image display layer is a liquid crystal layer, and in case where the above-mentioned image display medium is a self-luminous display as mentioned above, a fluorescent material layer having a fluorescent material corresponds to the above-mentioned image display layer.

### Examples

The present invention will be more concretely described by showing examples and comparative examples in the following section.

### 1. Determination of preferred Si:O:C ratios of vapour deposition film.

### (Comparative Example 1-1)

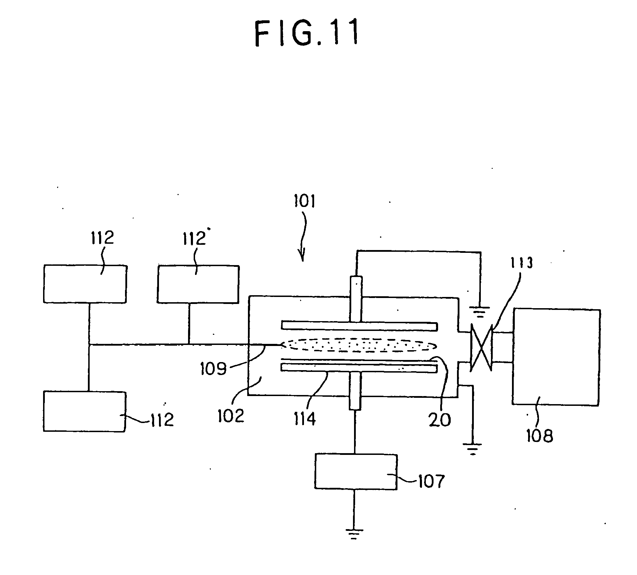

As shown Fig. 11, a sheet-shaped (30 cm × 21 cm) biaxial oriented polyamide film (made by Toyobo Co., Ltd., N1102, 15 µm in thickness) was prepared as a base material 20 and loaded on the side of the lower part electrode 114 within a chamber 102 of a plasma CVD device 101. Next, the inner part of the chamber 102 of the CVD device 101 was depressurized to the ultimate vacuum of 3.0 × 10⁻⁵ Torr (4.0 × 10⁻³ Pa) with an oil rotary pump and a turbopump. And as raw material gases 112, hexamethyldisiloxane (HMDSO) gas (Toray Dow Corning Silicon Co., Ltd., SH200, 0.65 cSt) and oxygen gas (Taiyo Toyo Sanso Co., Ltd., 99.9999% or more in purity) were prepared.

Next, electric power having the frequency of 90 kHz (closing electric power: 300 W) was applied to the lower part electrode 114. And HMDSO gas of 1 sccm, oxygen gas of 10 sccm and helium gas of 30 sccm were introduced through a gas introduction opening 109 attached near the electrode in the chamber 102 and the pressure within the chamber during film forming was kept at 0.25 Torr (33.325 Pa) by controlling the degree of opening and closing of a valve 113 between a vacuum pump 108 and the chamber 102 to form a film of silicon oxide as a vapor deposition film 3 on the base material film 2. Here, sccm is an abbreviation of standard cubic cm per minute. Film forming was continued until the film thickness was 100 nm and a gas barrier film of comparative example 1-1 was obtained.

### (Comparative Example 1-2)

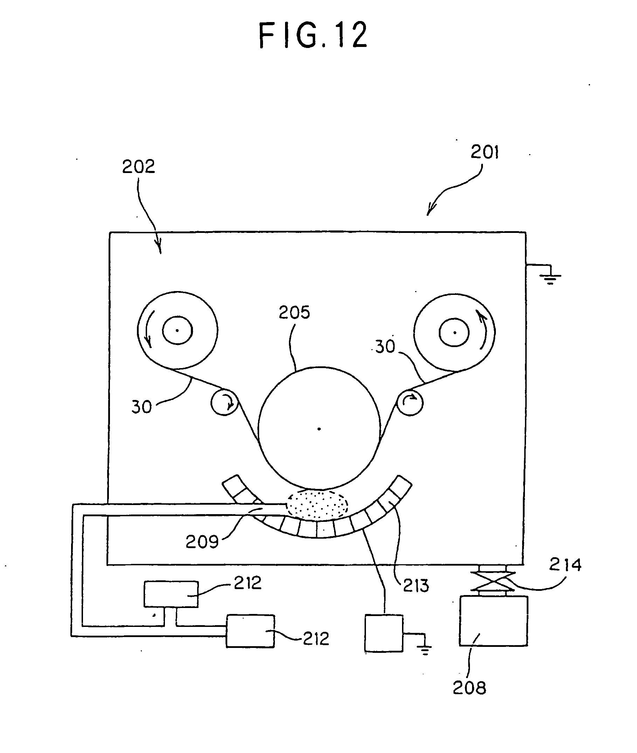

As shown Fig. 12, a roll-shaped biaxial oriented polyamide film (made by Toyobo Co., Ltd., N1102, 15 µm in thickness, 600 mm in width, and 5000 m in length) was prepared as a base material 40 and loaded within a chamber 202 of a plasma CVD device 201 equipped with a winding mechanism. Next, the inner part of the chamber 202 of the CVD device 201 was depressurized to the ultimate vacuum of 3.0 × 10⁻⁵ Torr (4.0 × 10⁻³ Pa) with an oil rotary pump and an oil diffusion pump. And as raw material gas 212, tetramethoxysilane (TMOS) gas (Shin-Etsu Chemical Co., Ltd., KBM04) and oxygen gas (Taiyo Toyo Sanso Co., Ltd., 99.9999% or more in purity) were prepared.

Next, near a coating drum 205, a piece of electrode 213 was arranged so as to oppose to the coating drum 205, and high-frequency electric power having the frequency of 40 kHz (closing electric power: 3.0 kW) was applied between this coating drum 205 and an electrode 213. And TMOS gas of 50 sccm and oxygen gas of 500 sccm were introduced through a gas introduction opening 209 attached near the electrode 213 in the chamber 202 and the pressure within the chamber during film forming was kept at 5 x 10⁻² Torr (6.7 Pa) by controlling the degree of opening and closing of a valve 214 between a vacuum pump 208 and the chamber 202 to form a film of silicon oxide as a vapor deposition film on the base material film 40. The traveling speed of the base material film 40 was set so that the film thickness was 100 nm and a gas barrier film of comparative example 1-2 was obtained.

### (Example 1-3)

Except that the traveling speed of a base material film was set so that the film thickness of a silicon oxide film was 10 nm, the same operation as comparative example 1-2 was carried out and a gas barrier film of example 1-3 was obtained.

### (Comparative examples 1-3 to 1-7)

Except that hexamethyldisiloxane gas and oxygen gas were introduced under such conditions as shown in Table 1 and the flow rates and flow ratios of those gases and pressure during film forming were adjusted, film forming operations were carried out under the same conditions as comparative example 1-1 and gas barrier films of comparative examples 1-3 to 1-7 were obtained.

### (Evaluation method)

Components of silicon oxide films were measured with ESCA (ESCA LAB220 i-XL, made by VG Scientific Co., England). Monochrome Al X-ray source of Ag-3d-5/2 peak strength and of 300 K to 1 Mcps as a X-ray source, and a slit of about 1 mm ϕ in diameter were used. Measurement was carried out at the state that the detector was set on the normal line to the surface of a sample provided for measurement and electrification was appropriately compensated. Analysis after measurement was carried out with each peak corresponding to binding energy of Si : 2 p, C : 1 s, and O : 1 s, using the Software Eclipse version 2.1 (made by VG Scientific Co., England) which is attached to the ESCA device mentioned above. At this time, Shirley's background noise was removed to each peak and sensitivity coefficient compensation of each atom (When C = 1, Si = 0.817 and O = 2.930) was provided to the peak area, and then the ratio of the number of atoms was calculated. Based on the obtained ratio of the number of atoms, when the number of Si atom was 100, the number of O and C, which are other components, were calculated and used to evaluated the rate of each component.

IR measurement was carried out with a Fourier transform infrared spectrophotometer (Herschel FT/IR-610, made by Nihon Bunko Co., Ltd.) equipped with ATR (multiple reflection unit) (ATR-300/H, made by Nihon Bunko Co., Ltd.). Infrared absorption spectra were measured using a germanium crystal as a prism at the angle of incidence of 45°.

The refractive indexes of silicon oxide films were measured with an optical spectroscope (UV-3100PC, made by Shimadzu Corp.). From obtained measurements results on transmittance and reflectance, refractive indexes at 633 nm were evaluated using the optical interference method.

About obtained gas barrier films, gas barrier properties were evaluated by measuring oxygen transmission rate and water vapor transmission rate. Oxygen gas transmission rate was measured at 23 °C under a dry condition (0% Rh) using an oxygen gas transmission rate measuring unit (OX-TRAN 2/20, made by MOCON Co.). Water vapor transmission rate was measured at 37.8 °C under a condition of 100% Rh using a water vapor transmission rate measuring unit (PERMATRAN-W 3/31, made by MOCON Co.). Criteria for evaluating gas barrier properties were set to be 0.5 cc/m²/day or less for oxygen gas transmission rate (OTR) and 0.5 g/m²/day or less for water vapor transmission rate (WVTR).

**[Table 1]**

| | Flow rate of raw material gases (sccm) | | Pressure during film forming (mTorr) | Closing electric power (W) | Film thickness (nm) | Ratio of the number of atoms Si : O : C | Position of Si-O-Si absorption peak (cm⁻¹) | Refractive index 633 nm | Oxygen transmission rate cc/m²/day | Water vapor transmission rate g /m²/day |
|---|---|---|---|---|---|---|---|---|---|---|
| | Organic silicon compound gas | Oxygen gas | | | | | | | | |
| Comparative Example 1-1 | 1 | 10 | 250 | 300 | 100 | 100:185: 13 | 1060 | 1.47 | 0.08 | 0.30 |
| Comparative Example 1-2 | 50 | 500 | 50 | 3000 | 100 | 100:180: 18 | 1063 | 1.47 | 0.06 | 0.15 |
| Example 1-3 | 50 | 500 | 50 | 3000 | 10 | 100:175: 20 | 1060 | 1.47 | 0.08 | 0.28 |
| Comparative Example 1-3 | 4 | 2 | 250 | 300 | 100 | 100:128: 83 | 1066 | 1.42 | 120 | 44 |
| Comparative Example 1-4 | 4 | 20 | 250 | 300 | 100 | 100:165: 40 | 1050 | 1.52 | 4 | 3 |
| Comparative Example 1-5 | 4 | 20 | 250 | 50 | 100 | 100:160: 75 | 1055 | 1.48 | 38 | 32 |
| Comparative Example 1-6 | 4 | 50 | 250 | 300 | 100 | 100:173: 30 | 1045 | 1.48 | 2.5 | 3.5 |
| Comparative Example 1-7 | 4 | 20 | 500 | 300 | 100 | 100:163: 45 | 1062 | 1.44 | 118 | 43 |

| | | | | | | | | | | |
|---|---|---|---|---|---|---|---|---|---|---|
| Note) 1 mTorr = 1 × 10⁻³ Torr = 1.333 × 10⁻¹ Pa | | | | | | | | | | |

### (Measurement results)

In any of gas barrier films of comparative examples 1-1 to 1-2 or example 1-3, oxygen gas transmission rate (OTR) was 0.5 cc/m² /day or less and water vapor transmission rate (WVTR) was 0.5 g/m² /day or less, and they showed excellent gas barrier properties, while in comparative examples 1-3 to 1-7, both oxygen gas transmission rate (OTR) and water vapor transmission rate (WVTR) exceeded evaluation criteria and they showed insufficient gas barrier properties.

### 2. Measurement of grain spacing L

### [1] Case of using plasma CVD method

### (Comparative Examples 2-1 to 2-2 and Example 2-3)

Comparative Examples 2-1 to 2-2 and example 2-3 were obtained in like manner as in Comparative Examples 1-1 to 1-2 and Example 1-3.

### (Comparative Examples 2-3 to 2-7)

Hexamethyldisiloxane gas and oxygen gas were introduced at conditions shown in Table 2 below, films were formed at the similar conditions as in Comparative Example 2-1 except that their gas flows, flow ratios, and film forming pressures were adjusted, and gas barrier films of Comparative Examples 2-3 to 2-7 were obtained.

### (Measurement method of distance between grains by interatomic force microscope)

Since the deposition film prepared by the above-mentioned plasma CVD method has a smooth surface under no treatment, grains cannot be directly measured. Accordingly, firstly, the surface was treated with hydrofluoric acid or aqueous ammonium fluoride solution. Said treatment is a method of utilizing a nature in which boundaries are dissolved but grains are hardly dissolved, and it became possible to observe the grains which were formed on the surface of the deposition film.

And after the sample after film forming was cut to a size of 10cm x 10cm, (1) it was treated at 23 °C with in 0.5% hydrofluoric acid solution for 5 seconds, (2) washed with water for 60 seconds, and (3) drying was carried out.

Here, the measurement method of distance between grains by an interatomic force microscope (hereinafter, it is referred to as "AFM") is illustrated.

AFM such as one manufactured by Digital Instruments Co., Ltd., one manufactured by Seiko Electronics Co., Ltd., one manufactured by Topometrix Co., Ltd., or the like can be used for the measurement, but Nano Scope III manufactured by Digital Instruments Co., Ltd. was used at this time. Further, in this case, after flat treatment of AFM image which was obtained by measuring surface shape at an area size of 500 nm × 500 nm, an arbitrary section was observed, and a distance between the peak and the adjacent peak was measured, concerning two adjacent grains whose peak height is nearly the same. Further, a cantilever in a condition in which wear and strain are not found is used for the measurement, and an homogeneous uneven region having no remarkable dent and no protrusion was made as a measurement spot.

Further, the above-mentioned tapping mode is illustrated in Q. Zong et al, "Surface Science Letter, Vol.290 (1993), L688-690". It is a method of exciting a cantilever in which a probe is provided on the edge around a resonance frequency (about 50 to 500 MHz) using a piezo exciter and scanning it on the surface of a sample while intermittently touching slightly, and a method of moving the position of the cantilever to an uneven direction (Z direction) so as to make constant the variation amount of amplitude detected and measuring a three dimensional surface form by a signal based on the movement to the Z-direction and by a signal in a planar direction (XY-direction). Further, the above-mentioned flat treatment is that concerning two dimensional data, the correction of the slope is treated by one dimensional, two dimensional, or three dimensional function based on a standard plane, and the undulation of a whole plane was counterbalanced by the treatment.

### (Measurement of gas permeability)

Concerning the gas barrier films obtained, the measurement of an oxygen gas transmission rate and the measurement of a water vapor transmission rate were carried out to evaluate gas barrier property. The oxygen gas transmission rate was measured at conditions of 23 °C and dry (0% Rh) using an oxygen gas transmission rate measurement device (MOCON Co., Ltd., OX-TRAN 2/20). The water vapor transmission rate was measured at conditions of 37.8 °C and 100% Rh using a water vapor transmission rate measurement device (MOCON Co., Ltd., PERMATRAN-W 3/31). The evaluation criteria were referred to as criteria that the oxygen gas transmission rate (OTR) is 0.5 cc/m²/day or less and the water vapor transmission rate (WVTR) is 0.5 g/m²/day or less.

### (Measurement result)

As was clear from the results, any of the gas barrier films of Comparative Examples 2-1 to 2-2 and Example 2-3 had the oxygen gas transmission rate (OTR) of 0.5 cc/m²/day or less and the water vapor transmission rate (WVTR) of 0.5 g/m²/day or less, and revealed excellent gas barrier property. To the contrary, the gas barrier films of Comparative Examples 2-3 to 2-7 had the oxygen gas transmission rate (OTR) and the water vapor transmission rate (WVTR) which exceed the evaluation criteria, and revealed inadequate gas barrier property.

### [2] Case of using ion plating method

### (Comparative Example 2-8)

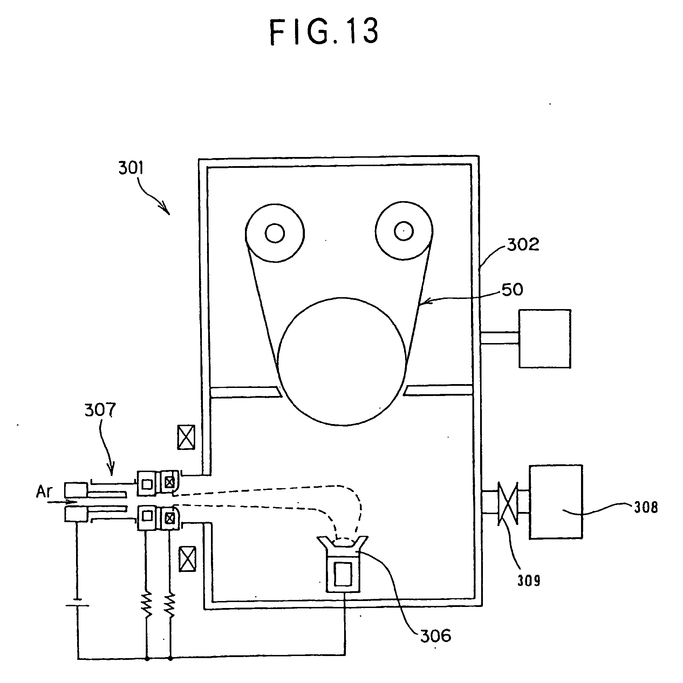

As shown in Fig. 13, a roll shape biaxially oriented poly (ethylene terephthalate) film (Unichika Co., Ltd., PET, a thickness of 12 µm) was used as a substrate film 50, and mounted in the chamber 302 of a winding-up type hollow cathode discharge ion plating device 301. Then, silicon dioxide (Merk Japan Co., Ltd., a purity of 99%, a particle diameter of 2.5 to 4 mm) was prepared as a deposition source, and mounted on an anode (hearth) 306. Then, the inside pressure of the chamber 302 was reduced to an attained vacuum of 1 × 10⁻⁵ Torr by an oil-sealed rotary pump and an oil diffusion pump.

Then, the substrate film was run by controlling the degree of opening and closing of a valve 309 which was situated between a vacuum pump 308 and the chamber while keeping the pressure of the chamber at 5 × 10⁻⁴ Torr during film forming, 5 kW of power for preparing plasma was charged to a hollow cathode discharge type plasma gun 307 where 20 sccm of argon gas was introduced, the deposition source was evaporated by converging plasma flow on the deposition source on the anode (hearth) 306 to be irradiated, deposition molecule was ionized by high density plasma, and a silicon oxide film as a deposition film was formed on the substrate film 50. Further, the run speed of the substrate film 50 was set so that the thickness of the silicon oxide film formed is 100 nm.

### (Comparative Example 2-9)

Film forming was carried out at the wholly same conditions as in Comparative Example 2-8 except that oxygen gas introduced during film forming was introduced at 10 sccm, to obtain the gas barrier film of Comparative Example 2-9.

### (Comparative Example 2-10)

Film forming was carried out at the wholly same conditions as in Comparative Example 2-8 except that power charged during film forming was set at 3.5 kW, to obtain the gas barrier film of Comparative Example 2-10.

### (Comparative Example 2-11)

Film forming was carried out at the wholly same conditions as in Comparative Example 2-8 except that the pressure of the chamber during film forming was set at 1 × 10⁻³ Torr during film forming, to obtain the gas barrier film of Comparative Example 2-11.

### (Measurement of gas permeability)

Concerning the gas barrier films obtained, the measurement of an oxygen gas transmission rate and the measurement of a water vapor transmission rate were carried out to evaluate gas barrier property. The oxygen gas transmission rate was measured at conditions of 23 °C and dry (0% Rh) using an oxygen gas transmission rate measurement device (MOCON Co., Ltd., OX-TRAN 2/20). The water vapor transmission rate was measured at conditions of 37.8 °C and 100% Rh using a water vapor transmission rate measurement device (MOCON Co., Ltd., PERMATRAN-W 3/31). The evaluation criteria were referred to as criteria that the oxygen gas transmission rate (OTR) is 0.5 cc/m²/day or less and the water vapor transmission rate (WVTR) is 0.5 g/m²/day or less.

### (Measurement result)

Measurement results are shown in Table 2 below.

**[Table 2]**

| | Oxygen gas transmission rate (cc/m²/day·atm) | Water vapor transmission rate (g/m²/day) | Distance between grains (nm) |
|---|---|---|---|
| Comparative Example 2-8 | 0.03 | 0.30 | 24 |
| Comparative Example 2-9 | 0.15 | 0.45 | 20 |
| Comparative Example 2-10 | 0.92 | 1.84 | 42 |
| Comparative Example 2-11 | 1.22 | 1.56 | 47 |

As cleared also from the above-mentioned Table 2, any of the gas barrier films of Comparative Examples 2-8 to 2-9 had the oxygen gas transmission rate (OTR) of 0.5 cc/m²/day or less and the water vapor transmission rate (WVTR) of 0.5 g/m²/day or less, and revealed excellent gas barrier property. To the contrary, the gas barrier films of Comparative Examples 2-10 to 2-11 had both the oxygen gas transmission rate (OTR) and the water vapor transmission rate (WVTR) which exceed the evaluation criteria, and revealed inadequate gas barrier property.

### [3] Case of using sputtering method

### (Comparative Example 2-12)

A sheet shape biaxially oriented polyethylene terephthalate film having a size of 10cm × 10cm (Unichika Co., Ltd., PET, a thickness of 12 µm) was used as a substrate film, and mounted in the chamber of a batchwise sputtering film forming device (ANELBA Co., Ltd., SPF-730H). Then, silicon (a purity of 99.9999% or more) was prepared as a sputtering target material, and mounted in the chamber. Then, argon gas (Taiyo Toyo Sanso Co., Ltd., a purity of 99.9999% or more) and oxygen gas (Taiyo Toyo Sanso Co., Ltd., a purity of 99.9999% or more) were prepared as gases added during film forming.

Then, the inside pressure of the chamber was reduced to an attained vacuum of 2 × 10⁻³ Pa by an oil-sealed rotary pump and a cryopump. The film forming of a silicon oxide film as a deposition film was carried out by a charged power of 200W according to a DC magnetron sputtering method, by introducing 30 sccm of argon gas and 5 sccm of oxygen gas and keeping the pressure of the chamber at 0.1 Pa during film forming by controlling the degree of opening and closing of a valve which was situated between a vacuum pump and the chamber. The film forming time was set so that the thickness of the silicon oxide film is 100 nm, and the gas barrier film of Comparative Example 2-12 was obtained.

### (Comparative Example 2-13)

Film forming was carried out at the wholly same conditions as in Comparative Example 2-12 except that film forming pressure was set at 0.05 Pa, to obtain the gas barrier film of Comparative Example 2-13.

### (Comparative Example 2-14)

Film forming was carried out at the wholly same conditions as in Comparative Example 2-12 except that charged power was set at 400W, to obtain the gas barrier film of Comparative Example 2-14.

### (Comparative Example 2-15)

Film forming was carried out at the wholly same conditions as in Comparative Example 2-12 except that an oxygen gas flow was set at 15 sccm, to obtain the gas barrier film of Comparative Example 2-15.

### (Comparative Example 2-16)

Film forming was carried out at the wholly same conditions as in Comparative Example 2-12 except that an argon gas flow was set at 60 sccm, to obtain the gas barrier film of Comparative Example 2-16.

### (Measurement of gas permeability)

Concerning the gas barrier films obtained, the measurement of an oxygen gas transmission rate and the measurement of a water vapor transmission rate were carried out to evaluate gas barrier property. The oxygen gas transmission rate was measured at conditions of 23 °C and dry (0% Rh) using an oxygen gas transmission rate measurement device (MOCON Co., Ltd., OX-TRAN 2/20). The water vapor transmission rate was measured at conditions of 37.8 °C and 100% Rh using a water vapor transmission rate measurement device (MOCON Co., Ltd., PERMATRAN-W 3/31). The evaluation criteria of the gas barrier property were referred to as criteria that the oxygen gas transmission rate (OTR) is 0.5 cc/m²/day or less and the water vapor transmission rate (WVTR) is 0.5 g/m²/day or less.

### (Measurement result)

Measurement results are shown in Table 3 below.

**[Table 3]**

| | Oxygen gas transmission rate (cc/m²/day·atm) | Water vapor transmission rate (g/m²/day) | Distance between grains (nm) |
|---|---|---|---|
| Comparative Example 2-12 | 0.21 | 0.20 | 23 |
| Comparative Example 2-13 | 0.11 | 0.23 | 18 |
| Comparative Example 2-14 | 0.23 | 0.38 | 25 |
| Comparative Example 2-15 | 0.75 | 0.84 | 42 |
| Comparative Example 2-16 | 1.12 | 1.36 | 49 |

As cleared also from the above-mentioned Table 3, any of the gas barrier films of Comparative Examples 2-12 to 2-14 had the oxygen gas transmission rate (OTR) of 0.5 cc/m²/day or less and the water vapor transmission rate (WVTR) of 0.5 g/m²/day or less, and revealed excellent gas barrier property. To the contrary, the gas barrier films of Comparative Examples 2-15 to 2-16 had both the oxygen gas transmission rate (OTR) and the water vapor transmission rate (WVTR) which exceed the evaluation criteria, and revealed inadequate gas barrier property.

### 3. Measurement of density of E' centers using ESR

### (Comparative Examples 3-1 to 3-2 and Example 3-3)

The gas barrier films of Comparative Examples 3-1 to 3-2 and Example 3-3 were obtained using the similar method as in Comparative Examples 1-1 to 1-2 and Example 1-3.

### (Comparative Examples 3-3 to 3-7)

The gas barrier films of Comparative Example 3-3 to Comparative Example 3-7 were obtained by the principally similar method as in the above-mentioned Comparative Example 3-1.

Provided that the respective parameters (gas flows of an organic silicon compound (HMDSO) gas, oxygen gas flows, film forming pressures, charged powers, thicknesses) were set as values shown in Table 4 below.

### (Measurement method of electron spin resonance method (ESR method))

Concerning each of the silicon oxide films prepared by the above-mentioned plasma CVD method, the density of E' center was measured by an electron spin resonance method (ESR method). Devices and measurement conditions used for the measurement were below.

### (Measurement device)

Main device: ESR350E (BRUKER Co., Ltd.)
- Accessory device:: HP5351B microwave frequency counter (HEWLETT PACKARD Co., Ltd.), ER035M gauss meter (BRUKER Co., Ltd.), and ESR910 cryostat (OXFORD Co., Ltd.)

### (Measurement condition)

- Measurement temperature:: Room temperature (23 °C)
- Magnetic field sweep range:: 331.5 to 341.5 mT
- Modulation:: 100 kHz, 0.2 mT
- Microwave:: 9.43 GHz, 0.1 mW
- Sweep time:: 83.886 sec. × 4 times
- Time constant:: 327.68 msec.
- Data point:: 1024
- Cavity:: TM₁₀, cylindrical type

### (Analytical method)

A signal derived from the E' center in a silica film was observed nearby g = 2.0003. ESR spectrum is usually obtained as a differential curve, an absorption curve is obtained by differentiation once, and signal intensity (area intensity) is obtained by differentiation twice. Spin figure represents the number of unpaired electrons, and it is a value determined by the afore-mentioned signal intensity using a polyethylene film which was ion-implanted as the secondary standard sample. Further, copper sulfate 5-hydrate was used for the first standard sample.

Those obtained by standardizing the E' center number by the film thickness and measurement area are determined as the E' center density. Further, the detection limit of the E' center in the above-mentioned devices (devices used in Examples and Comparative Examples) was 5 × 10¹⁵ spins/cm³.

### (Measurement result)

Measurement results are shown in Table 4 below.

**Table 4]**

| | Organic silicon compound gas (sccm) | Oxygen gas (sccm) | Pressure during film forming (mTorr) | Closing electric power (W) | Film thickness (nm) | Distance between grains (nm) | Oxygen gas transmission rate (cc/m² /day·atm) | Water vapor transmission rate (g/m²/day) |
|---|---|---|---|---|---|---|---|---|
| Comparative Example 3-1 | 1 | 10 | 250 | 300 | 100 | 18 | 0.08 | 0.30 |
| Comparative Example 3-2 | 50 | 500 | 50 | 3000 | 100 | 21 | 0.06 | 0.15 |
| Example 3-3 | 50 | 500 | 50 | 3000 | 10 | 22 | 0.08 | 0.28 |
| Comparative Example 3-3 | 4 | 2 | 250 | 300 | 100 | 90 | 120 | 44 |
| Comparative Example 3-4 | 4 | 2 | 250 | 300 | 100 | 61 | 4 | 3 |
| Comparative Example 3-5 | 4 | 20 | 250 | 50 | 100 | 85 | 38 | 32 |
| Comparative Example 3-6 | 4 | 50 | 250 | 300 | 100 | 45 | 2.5 | 3.5 |
| Comparative Example 3-7 | 4 | 20 | 500 | 300 | 100 | 92 | 118 | 43 |

As cleared also from the above-mentioned Table 4, any of the gas barrier films of Comparative Examples 3-1 to 3-2 and Example 3-3 had the oxygen gas transmission rate (OTR) of 0.5 cc/m²/day or less and the water vapor transmission rate (WVTR) of 0.5 g/m²/day or less, and revealed excellent gas barrier property. To the contrary, the gas barrier films of Comparative Examples 3-3 to 3-7 had both the oxygen gas transmission rate (OTR) and the water vapor transmission rate (WVTR) which exceed the evaluation criteria, and revealed inadequate gas barrier property.

### 4. Measurement of absorbed CO by IR spectroscopy

### (Comparative Examples 4-1 to 4-2)

The gas barrier films of Comparative Examples 4-1 to 4-2 and Example 4-3 were obtained using the similar method as in Comparative Examples 1-1 to 1-2 and Example 1-3.

### (Comparative Examples 4-3 to 4-7)

The gas barrier films of Comparative Example 4-3 to Comparative Example 4-7 were obtained by the principally similar method as in the above-mentioned Comparative Example 4-1.

### (IR measurement)

IR measurement was carried out by a Fourier transform type infra-red rays spectrophotometer (NIHON BUNKOU Co., Ltd., Herschel FT/IR-610) equipped with an ATR (multiple reflection) measurement device (NIHON BUNKOU Co., Ltd., ATR-300/H). Infra-red rays spectra were measured at an incidence angle of 45° using germanium crystal as a prism.

### (Evaluation result)

Concerning the gas barrier films obtained, the measurement of an oxygen gas transmission rate and the measurement of a water vapor transmission rate were carried out to evaluate gas barrier property. The oxygen gas transmission rate was measured at conditions of 23 °C and dry (0% Rh) using an oxygen gas transmission rate measurement apparatus (MOCON Co., Ltd., OX-TRAN 2/20). The water vapor transmission rate was measured at conditions of 37.8 °C and 100% Rh using a water vapor transmission rate measurement apparatus (MOCON Co., Ltd., PERMATRAN-W 3/31). The evaluation criteria of the gas barrier property were referred to as criteria that the oxygen gas transmission rate (OTR) is 0.5 cc/m²/day or less and the water vapor transmission rate (WVTR) is 0.5 g/m²/day or less.

As was clear from the results, any of the gas barrier films of Comparative Examples 4-1 to 4-2 and Example 4-3 had the oxygen gas transmission rate (OTR) of 0.5 cc/m²/day or less and the water vapor transmission rate (WVTR) of 0.5 g/m²/day or less, and revealed excellent gas barrier property. To the contrary, the gas barrier films of Comparative Examples 4-3 to 4-7 had both the oxygen gas transmission rate (OTR) and the water vapor transmission rate (WVTR) which exceed the evaluation criteria, and revealed inadequate gas barrier property.

### (Heat treatment)

Heat treatment was carried out at various conditions for the gas barrier films of Comparative Examples 4-1 to 4-2 and Example 4-3. The conditions of the heat treatment and the evaluation results of the oxygen gas transmission rate (OTR) and the water vapor transmission rate (WVTR) were summarized in Table 5. Further, evaluation methods are similar as the methods described above.

**[Table 5]**

| | Sample | Heat treating condition | Strength of an infrared adsorption peak at 2341 cm⁻¹ (Absorbance) | Oxygen gas transmission rate (cc/m²/day·atm | Water vapour transmission rate (g/m²/day) |
|---|---|---|---|---|---|
| | Comparative Example 4-1 | None | Be found (0.02) | 0.08 | 0.30 |
| | Comparative Example 4-2 | | Be found (0.08) | 0.06 | 0.15 |
| | Example 4-3 | | Be found (0.01) | 0.08 | 0.28 |
| Comparative Example 4-8 | Comparative Example 4-1 | 40°C x 5 minutes | Be found (0.02) | 0.08 | 0.28 |
| Comparative Example 4-9 | Comparative Example 4-2 | | Be found (0.08) | 0.06 | 0.16 |
| Comparative Example 4-10 | Example 4-3 | | Be found (0.01) | 0.07 | 0.29 |
| Comparative Example 4-11 | Comparative Example 4-1 | 40°C x 60 minutes | Be found (0.02) | 0.07 | 0.29 |
| Comparative Example 4-12 | Comparative Example 4-2 | | Be found (0.08) | 0.06 | 0.14 |
| Comparative Example 4-13 | Example 4-3 | | Be found (0.01) | 0.08 | 0.28 |
| Comparative Example 4-14 | Comparative Example 4-1 | 55°C x 5 minutes | Be found (0.01) | 0.05 | 0.25 |
| Comparative Example 4-15 | Comparative Example 4-2 | | Be found (0.05) | 0.03 | 0.10 |
| Comparative Example 4-16 | Example 4-3 | | Be found (0.01) | 0.05 | 0.22 |
| Comparative Example 4-17 | Comparative Example 4-1 | 55°C x 30 minutes | None (<0.005) | 0.02 | 0.12 |
| Comparative Example 4-18 | Comparative Example 4-2 | | None (<0.005) | 0.01 | 0.05 |
| Comparative Example 4-19 | Example 4-3 | | None (<0.005) | 0.03 | 0.13 |
| Comparative Example 4-20 | Comparative Example 4-1 | 70°C x 5 minutes | None (<0.005) | 0.01 | 0.08 |
| Comparative Example 4-21 | Comparative Example 4-2 | | None (<0.005) | 0.01 | 0.06 |
| Comparative Example 4-22 | Example 4-3 | | None (<0.005) | 0.02 | 0.10 |

As cleared also from Table 5, even when the heat treatment was carried out for 60min. in case of heating at 40 °C, and when heating was carried out at 55 °C, the peak (2341 cm⁻¹) of IR absorption based on the stretching vibration of CO molecule exists in a sample treated for 5 minutes by heating, and the improvements of the oxygen gas transmission rate and the water vapor transmission rate were not observed in this case. However, the peak (2341 cm⁻¹) of IR absorption based on the stretching vibration of CO molecule is less than the detection limit of the analytical instrument in case of a sample treated at 55 °C for 30 minutes by heating and a sample treated at 70 °C for 5 minutes by heating, and the oxygen gas transmission rate and the water vapor transmission rate were improved.

## Claims

1. A gas barrier film comprising a base material and a silicon oxide vapour deposition film formed on both sides or one side of the base material, wherein: the silicon oxide film is formed by the plasma CVD method and contains from 170 to 200 oxygen atoms and 30 or less carbon atoms per 100 silicon atoms, and further has an IR absorption peak based on the stretching vibration of Si-O-Si between 1055 and 1065 cm⁻¹;
the distance between grains formed on the surface of said silicon oxide vapour deposition film is from 5 to 40 nm;
the thickness of the silicon oxide vapour deposition film is from 5 nm to 30 nm; and the silicon oxide film has a refractive index of 1.45 to 1.48.

2. A gas barrier film according to Claim 1, wherein said silicon oxide film has an E' centre that is observable by measurement with the electron spin resonance method (ESR method).

3. A gas barrier film according to Claim 2, wherein the density of said E' centre is 5 x 10¹⁵ spins/cm³ or more.

4. A gas barrier film as claimed in Claim 1, wherein said silicon oxide film has an infrared peak based on the stretching vibration of CO molecules between 2341±4 cm⁻¹.

5. A gas barrier film according to any of Claims 1 to 4, wherein the oxygen transmission rate is 0.5 cc/m²/day or less and the water vapour transmission rate is 0.5 g/m²/day or less.

6. A laminated material, wherein a heat sealable resin layer is provided on the surface of at least one side of a gas barrier film according to any of Claims 1 to 5.

7. A packaging container, wherein a laminated material according to Claim 6 is used and said heat sealable resin is heat-sealed to make a bag or case.

8. A laminated material, wherein an electrically conductive layer is formed on the surface of at least one side of the gas barrier film according to any of Claims 1 to 5.

9. An image display medium, wherein an image display layer is formed on said electrically conductive layer using a laminated material according to Claim 8 as a base material.

## Patentansprüche

1. Gassperrfilm, umfassend ein Basismaterial und einen auf beiden Seiten oder einer Seite des Basismaterials ausgebildeten Siliziumoxid-Aufdampffilm, wobei:
der Siliziumoxidfilm nach dem Plasma-CVD-Verfahren gebildet ist und 170 bis 200 Sauerstoffatome und 30 oder weniger Kohlenstoffatome pro 100 Siliziumatome enthält und des Weiteren basierend auf der Streckschwingung von Si-O-Si einen IR-Absorptionspeak zwischen 1055 und 1065 cm⁻¹ hat;
die Entfernung zwischen auf der Oberfläche des Siliziumoxid-Aufdampffilms gebildeten Körnern 5 bis 40 nm beträgt;
die Dicke des Siliziumoxid-Aufdampffilms 5 nm bis 30 nm beträgt; und
der Siliziumoxidfilm einen Brechungsindex von 1,45 bis 1,48 hat.

2. Gassperrfilm nach Anspruch 1, wobei der Siliziumoxidfilm ein E'-Zentrum hat, das durch eine Messung nach dem Elektronenspinresonanzverfahren (ESR-Verfahren) beobachtbar ist.

3. Gassperrfilm nach Anspruch 2, wobei die Dichte des E'-Zentrums 5 x 10¹⁵ Spins/cm³ oder größer ist.

4. Gassperrfilm nach Anspruch 1, wobei der Siliziumoxidfilm basierend auf der Streckschwingung von CO-Molekülen einen Infrarotpeak bei 2341±4 cm⁻¹ aufweist.

5. Gassperrfilm nach einem der Ansprüche 1 bis 4, wobei die Sauerstoffübertragungsrate 0,5 cc/m²/Tag oder weniger und die Wasserdampfübertragungsrate 0,5 g/m²/Tag oder weniger beträgt.

6. Geschichtetes Material, bei dem eine heißsiegelfähige Harzschicht auf der Oberfläche zumindest einer Seite eines Gassperrfilms nach einem der Ansprüche 1 bis 5 vorgesehen ist.

7. Packmittel, bei dem ein geschichtetes Material nach Anspruch 6 verwendet und das heißsiegelfähige Harz zum Ausbilden einer Tasche oder Hülle heißgesiegelt wird.

8. Geschichtetes Material, bei dem eine elektrisch leitende Schicht auf der Oberfläche zumindest einer Seite des Gassperrfilms nach einem der Ansprüche 1 bis 5 ausgebildet ist.

9. Bildanzeigemedium, bei dem unter Verwendung eines geschichteten Materials nach Anspruch 8 als Basismaterial eine Bildanzeigeschicht auf der elektrisch leitenden Schicht ausgebildet ist.

## Revendications

1. Film barrière contre les gaz comprenant un matériau de base et un film de dépôt en phase vapeur d'oxyde de silicium formé sur les deux côtés ou un côté du matériau de base, dans lequel :
le film d'oxyde de silicium est formé par le procédé de CVD au plasma et contient de 170 à 200 atomes d'oxygène et 30 atomes de carbone ou moins pour 100 atomes de silicium, et a en outre un pic d'absorption d'IR basé sur la vibration d'élongation de Si-O-Si entre 1 055 et 1 065 cm⁻¹ ;
la distance entre les grains formés sur la surface dudit film de dépôt en phase vapeur d'oxyde de silicium est de 5 à 40 nm ;
l'épaisseur du film de dépôt en phase vapeur d'oxyde de silicium est de 5 nm à 30 nm ; et
le film d'oxyde de silicium a un indice de réfraction de 1,45 à 1,48.

2. Film barrière contre les gaz selon la revendication 1, dans lequel ledit film d'oxyde de silicium a un centre E' qui peut être observé par mesure à l'aide du procédé de résonance paramagnétique électronique (procédé ESR).

3. Film barrière contre les gaz selon la revendication 2, dans lequel la densité dudit centre E' est de 5 x 10¹⁵ spins/cm³ ou plus.

4. Film barrière contre les gaz selon la revendication 1, dans lequel ledit film d'oxyde de silicium a un pic infrarouge basé sur la vibration d'élongation de molécules de CO entre 2 341 ± 4 cm⁻¹.

5. Film barrière contre les gaz selon l'une quelconque des revendications 1 à 4, dans lequel le coefficient de transmission d'oxygène est de 0,5 cm³/m²/jour ou moins et le coefficient de transmission de vapeur d'eau est de 0,5 g/m²/jour ou moins.

6. Matériau stratifié, dans lequel une couche de résine thermoscellable est prévue sur la surface d'au moins un côté d'un film barrière contre les gaz selon l'une quelconque des revendications 1 à 5.

7. Contenant de conditionnement, dans lequel un matériau stratifié selon la revendication 6 est utilisé et ladite résine thermoscellable est thermoscellée pour réaliser un sac ou boîtier.

8. Matériau stratifié, dans lequel une couche électroconductrice est formée sur la surface d'au moins un côté du film barrière contre les gaz selon l'une quelconque des revendications 1 à 5.

9. Support d'affichage d'image, dans lequel une couche d'affichage d'image est formée sur ladite couche électroconductrice en utilisant un matériau stratifié selon la revendication 8 comme matériau de base.
